(19) Europäisches Patentamt / European Patent Office / Office européen des brevets

(11) **EP 4 729 993 A1**

(12) **EUROPEAN PATENT APPLICATION**
published in accordance with Art. 153(4) EPC


(43) Date of publication:
**22.04.2026 Bulletin 2026/17**

(21) Application number: **24810981.1**

(22) Date of filing: **14.05.2024**

(51) International Patent Classification (IPC):
***G02B 5/00*** (2006.01) ***F21S 2/00*** (2016.01)
***F21V 5/00*** (2018.01) ***F21V 9/08*** (2018.01)
***F21V 9/40*** (2018.01) ***G02F 1/1335*** (2006.01)
***G02F 1/13357*** (2006.01) ***H10K 59/10*** (2023.01)
***F21Y 101/00*** (2016.01) ***F21Y 115/10*** (2016.01)

(52) Cooperative Patent Classification (CPC):
**F21S 2/00; F21V 5/00; F21V 9/08; F21V 9/40; G02B 5/00; G02F 1/1335; G02F 1/1336; H10K 59/10;** F21Y 2101/00; F21Y 2115/10

(86) International application number:
**PCT/JP2024/017814**

(87) International publication number:
**WO 2024/241974 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.05.2023 JP 2023083013**
**16.01.2024 JP 2024004541**



(71) Applicant: **Dai Nippon Printing Co., Ltd.**
**Tokyo 162-8001 (JP)**

(72) Inventors:
- **TAKAHATA, Sou**
**Tokyo 162-8001 (JP)**
- **OGAWA, Kazunobu**
**Tokyo 162-8001 (JP)**
- **SASAHARA, Kazuhiro**
**Tokyo 162-8001 (JP)**

(74) Representative: **Müller-Boré & Partner Patentanwälte PartG mbB**
**Friedenheimer Brücke 21**
**80639 München (DE)**


(54) **OPTICAL SHEET, PLANAR LIGHT SOURCE DEVICE, AND DISPLAY DEVICE**


(57) The present disclosure provides an optical sheet comprising a substrate layer, and an optical functional layer stacked on one surface of the substrate layer, wherein the optical sheet has a rectangular shape including a pair of first sides extending in a first direction and a pair of second sides extending in a second direction in a plan view; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and an extending direction of the light transmitting portion has an angle of 5° or more and 20° or less, with respect to the second direction.


[FIG. 1]

10
(10A～10H)
L1
L2
L2
L1
Observer
I
I
1
Up
Light source
(Vertical direction)
Down
D3
D2
D1
Left
Right
(Horizontal direction)
4
3
2


EP 4 729 993 A1

## Description

Technical Field

The present disclosure relates to an optical sheet, a planar light source device and a display device.

Background Art

Display devices such as monitors of televisions and computer include an image source that emits an image to be displayed, and also include an optical sheet that improves the quality of the image light and provides it to the observer side (for example, Patent Document 1 to Patent Document 3).

The direction of emission of the image light is often set to the front, and a viewing angle of a predetermined angle in longitudinal and lateral directions with respect to the front. This makes it possible to see the image projected on the screen not only from the front but also from a position with a certain angle. Meanwhile, to prevent peeking, the viewing angle is restricted, if necessary, the front direction being the main emitting direction. An optical sheet for this purpose is disclosed in, for example, Patent Document 4.

Citation List

Patent Documents

Patent Document 1: Japanese Patent Application Laid-Open (JP-A) No. 2009-080198
Patent Document 2: JP-A No. 2015-014681
Patent Document 3: JP-A No. 2017-215440
Patent Document 4: JP-A No. 2006-171701

Summary of Disclosure

Technical Problem

In recent years, a display device, for the purpose of entertainment or the like for the passenger sitting in the front passenger seat, may be installed in front of a front passenger seat of a vehicle such as an automobile. In such a display device for the front passenger seat, it is required to control the emission of image light toward the driver's side so as not to interfere with the driver's driving. However, when a conventional optical sheet is installed in a front passenger seat display device, for example, when the light transmittance (%) at front is regarded as 100%, the relative transmittance, that is the ratio of the light transmittance (%) in a direction ±30° inclined toward the lateral direction with respect to the front, is approximately 10%, and the relative transmittance, that is the ratio of the light transmittance (%) in a direction ±20° inclined toward the lateral direction with respect to the front, is approximately 55% so that light emission on the driver side is visible. Incidentally, in the case of a right-hand drive vehicle, the front passenger seat display is usually installed in a direction at least 20° to 30° inclined toward left, with respect to the driver's front. Similarly, in the case of left-hand drive vehicles, the front passenger seat display is usually installed in a direction at least 20° to 30° inclined toward right, with respect to the driver's front.

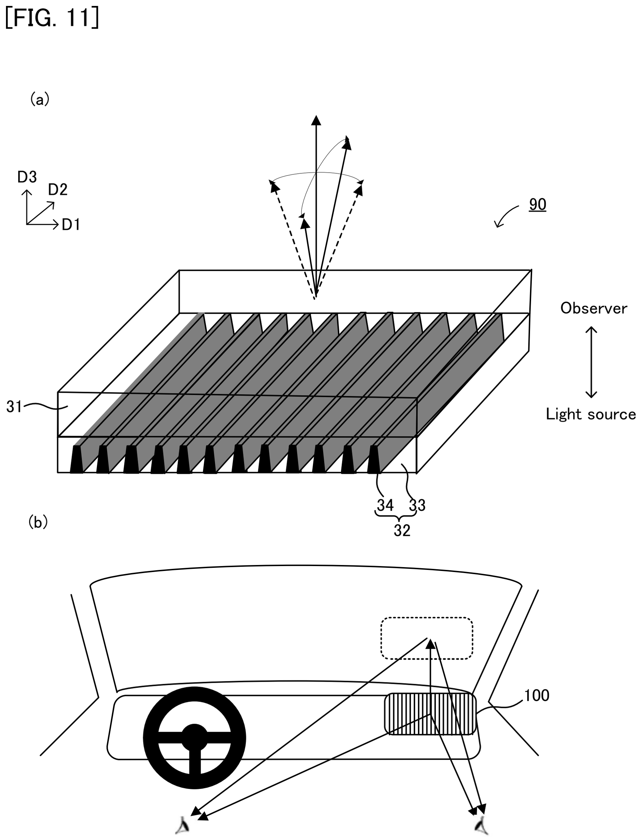

FIG. 11(a) shows a schematic perspective view of a conventional optical sheet. For example, the optical sheet 90 shown in FIG. 11(a) includes a layer (optical functional layer 32) including the portions configured to transmit light (light transmitting portion 33) that extends along one side direction of the sheet (second direction D2 in FIG. 11(a)), and the portions configured to absorb light (light absorbing portions 34) arranged alternately in parallel along the sheet surface. Such an optical sheet can only control the viewing angle in a direction (first direction D1 in FIG. 11(a)) perpendicular to the extending direction (second direction D2 in FIG. 11(a)) of the light transmitting portions 33 and the light absorbing portions 34, and it is difficult to control the viewing angle in a parallel direction (second direction D2 in FIG. 11(a)). Therefore, as shown in FIG. 11(b), when optical sheet 90 is used for the front passenger display device 100, the image light may be reflected on the front passenger seat side of the windshield of the vehicle. It is therefore also required to control the reflection on the windshield in front of the front passenger seat (lateral direction). Incidentally, in FIG. 11(b), the members other than the optical sheet of the display device 100 are omitted.

The present disclosure has been made in view of the above circumstances, and an object of the present disclosure is to provide an optical sheet capable of obtaining a display device wherein the emission of image light in longitudinal direction and lateral direction can be controlled. Specifically, an objective is to provide an optical sheet capable of obtaining a display device wherein, when used as an optical sheet for a display device installed in front of a front passenger seat of a vehicle, the emission of image light toward the driver's side can be controlled, and the reflection of the image light on the windshield in front of the front passenger seat can be controlled.

Solution to Problem

One embodiment of the present disclosure is an optical sheet comprising a substrate layer, and an optical functional layer stacked on one surface of the substrate layer, wherein the optical sheet has a rectangular shape including a pair of first sides extending in a first direction and a pair of second sides extending in a second direction in a plan view; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and an extending direction of the light transmitting portion has an angle of 5° or more and 20° or less, with respect to the second direction.

Another embodiment of the present disclosure is an optical sheet comprising a substrate layer, and an optical functional layer stacked on one surface of the substrate layer, wherein the optical sheet has a rectangular shape including a pair of first sides extending in a first direction and a pair of second sides extending in a second direction in a plan view; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; the optical sheet is an optical sheet for a display device installed in front of a front passenger seat of a vehicle; and an extending direction of the light transmitting portion has an angle of 5° or more and 20° or less, with respect to the second direction.

Another embodiment of the present disclosure is an optical sheet comprising a substrate layer, and an optical functional layer stacked on one surface of the substrate layer, wherein the optical sheet has a rectangular shape including a pair of first sides extending in a first direction and a pair of second sides extending in a second direction in a plan view; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and an extending direction of the light transmitting portion has an angle of 1.5° or more and 20° or less, with respect to the second direction.

Another embodiment of the present disclosure is an optical sheet comprising a substrate layer, and an optical functional layer stacked on one surface of the substrate layer, wherein the optical sheet has a rectangular shape including a pair of first sides extending in a first direction and a pair of second sides extending in a second direction in a plan view; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; the optical sheet is an optical sheet for a display device installed in front of a front passenger seat of a vehicle; and an extending direction of the light transmitting portion has an angle of 1.5° or more and 20° or less, with respect to the second direction.

Another embodiment of the present disclosure is an optical sheet comprising a substrate layer, and an optical functional layer stacked on one surface of the substrate layer, wherein the optical sheet has a rectangular shape including a pair of first sides extending in a first direction and a pair of second sides extending in a second direction in a plan view; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; when a light transmittance in a third direction perpendicular to the first direction and the second direction is regarded as 100%, a relative transmittance, that is a ratio of a light transmittance in a direction ±20° inclined toward the first direction with respect to the third direction, is 10% or less; and an extending direction of the light transmitting portion has an angle of 1.5° or more and 20° or less, with respect to the second direction.

Another embodiment of the present disclosure is an optical sheet comprising a substrate layer, and an optical functional layer stacked on one surface of the substrate layer, wherein the substrate layer is a resin substrate; in a plan view, the optical sheet has a rectangular shape including a pair of first sides extending in a first direction and a pair of second sides extending in a second direction; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; the optical sheet is an optical sheet for a display device installed in front of a front passenger seat of a vehicle; and an extending direction of the light transmitting portion has an angle of 1.5° or more and 20° or less, with respect to the second direction.

Another embodiment of the present disclosure is a planar light source device comprising the optical sheet described above; and a light source that emits light incident on the optical sheet.

Another embodiment of the present disclosure is a display device comprising the planar light source device described above; and a display panel stacked on the planar light source device.

Another embodiment of the present disclosure is a display device comprising a planar light source device including an optical sheet; and a display panel stacked on the planar light source device, wherein the optical sheet includes a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed, when a light transmittance in a normal line direction to a main surface of the optical sheet is regarded as 100%, a relative transmittance, that is a ratio of a light transmittance in a direction ±30° inclined laterally to the normal line direction, is 1% or less; and an extending direction of the light transmitting portion, viewed from the normal line direction, has an angle of 5° or more and 20° or less, with respect to a vertical direction.

Another embodiment of the present disclosure is a display device comprising a planar light source device including an optical sheet; and a display panel stacked on the planar light source device, wherein the display device is installed in front of a front passenger seat of a vehicle; the optical sheet is an optical sheet including a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed in front of a front passenger seat of a vehicle, an extending direction of the light transmitting portion, viewed from a normal line direction to a main surface of the optical sheet, has an angle of 5° or more and 20° or less, with respect to a vertical direction.

Another embodiment of the present disclosure is a display device comprising an optical sheet and a display panel, wherein the optical sheet includes a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed, when a light transmittance in a normal line direction to a main surface of the optical sheet is regarded as 100%, a relative transmittance, that is a ratio of a light transmittance in a direction ±30° inclined laterally to the normal line direction, is 1% or less; and an extending direction of the light transmitting portion, viewed from the normal line direction, has an angle of 1.5° or more and 20° or less, with respect to a vertical direction.

Another embodiment of the present disclosure is a display device comprising an optical sheet and a display panel, wherein the display device is installed in front of a front passenger seat of a vehicle; the optical sheet is an optical sheet including a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed in front of a front passenger seat of a vehicle, an extending direction of the light transmitting portion, viewed from a normal line direction to a main surface of the optical sheet, has an angle of 1.5° or more and 20° or less, with respect to a vertical direction.

Another embodiment of the present disclosure is a display device comprising an optical sheet and a display panel, wherein the optical sheet includes a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed, when a light transmittance in a normal line direction to a main surface of the optical sheet is regarded as 100%, a relative transmittance, that is a ratio of a light transmittance in a direction ±20° inclined laterally to the normal line direction, is 10% or less; and an extending direction of the light transmitting portion, viewed from the normal line direction, has an angle of 1.5° or more and 20° or less, with respect to a vertical direction.

Another embodiment of the present disclosure is a display device comprising an optical sheet and a display panel, wherein the display device is installed in front of a front passenger seat of a vehicle; the optical sheet includes a substrate layer, and an optical functional layer stacked on one surface of the substrate layer; the substrate layer is a resin substrate; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; and in the optical sheet, when the display device is installed in front of a front passenger seat of a vehicle, an extending direction of the light transmitting portion, viewed from a normal line direction to a main surface of the optical sheet, has an angle of 1.5° or more and 20° or less, with respect to a vertical direction.

Advantageous Effects of Disclosure

The present disclosure can provide an optical sheet capable of obtaining a display device wherein the emission of image light in longitudinal direction and lateral direction can be controlled. Further, the present disclosure can provide an optical sheet capable of obtaining a display device wherein, when used as an optical sheet for a display device installed in front of a front passenger seat of a vehicle, the emission of image light toward the driver's side can be controlled, and the reflection of image light on the windshield in front of the front passenger seat can be controlled.

Brief Description of Drawings

[FIG. 1] is a schematic perspective view exemplifying an optical sheet in the present disclosure.
[FIG. 2] is a schematic cross-sectional view exemplifying an optical sheet in the present disclosure.
[FIG. 3] is a schematic plan view exemplifying an optical sheet in the present disclosure.
[FIG. 4] is a schematic cross-sectional view exemplifying an optical sheet in the present disclosure.
[FIG. 5] is an exploded perspective view exemplifying a display device in the present disclosure.
[FIG. 6] is a part of an exploded cross-sectional view exemplifying a display device in the present disclosure.
[FIG. 7] is a part of an exploded cross-sectional view exemplifying a display device in the present disclosure.
[FIGS. 8] are a schematic view of the front of inside a vehicle wherein a display device in the present disclosure is installed as a front passenger seat display device, and a front view of the display device.
[FIG. 9] is a part of an exploded cross-sectional view exemplifying a display device in the present disclosure.
[FIG. 10] is a schematic cross-sectional view exemplifying an optical sheet in the present disclosure.
[FIGS. 11] are a schematic perspective view of a conventional optical sheet, and a schematic view of the front of inside a vehicle wherein it is installed as a front passenger seat display device.
[FIGS.12] are the measurement results of the relative transmittance (lateral direction) of the optical sheet in Example 4 and Comparative Example 8, and observation views of the display device including the optical sheet in Example 4 and Comparative Example 8.
[FIGS.13] are the measurement results of the relative transmittance (longitudinal direction) of the optical sheet in Example 4 and Comparative Example 8, and observation views of the display device including the optical sheet in Example 4 and Comparative Example 8.

Description of Embodiments

Embodiments in the present disclosure are hereinafter explained with reference to, for example, drawings. However, the present disclosure is implemented in a variety of different forms, and thus should not be taken as is limited to the contents described in the embodiments exemplified as below. Also, the drawings may show the features of the present disclosure such as width, thickness, and shape of each part schematically comparing to the actual form in order to explain the present disclosure more clearly in some cases; however, it is merely an example, and thus does not limit the interpretation of the present disclosure. Also, in the present descriptions and each drawing, for the factor same as that described in the figure already explained, the same reference sign is indicated and the detailed explanation thereof may be omitted.

In the present descriptions, on the occasion of expressing an aspect wherein some member is disposed on the other member, when described as merely "on" or "below", unless otherwise stated, it includes both of the following cases: a case wherein some member is disposed directly on or directly below the other member so as to be in contact with the other member, and a case wherein some member is disposed on the upper side or the lower side of the other member via yet another member. Also, in the present descriptions, on the occasion of expressing an aspect wherein some member is disposed on the surface of the other member, when described as merely "on the surface side" or "on the surface", unless otherwise stated, it includes both of the following cases: a case wherein some member is disposed directly on or directly below the other member so as to be in contact with the other member, and a case wherein some member is disposed on the upper side or the lower side of the other member via yet another member.

An optical sheet, a planar light source device, and a display device in the present disclosure will be hereinafter described in detail.

A-1. Optical sheet (first embodiment)

The optical sheet in the present embodiment is an optical sheet comprising a substrate layer, and an optical functional layer stacked on one surface of the substrate layer, wherein, in a plan view, the optical sheet has a rectangular shape including a pair of first sides extending in a first direction and a pair of second sides extending in a second direction; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; when a light transmittance in a third direction perpendicular to the first direction and the second direction is regarded as 100%, a relative transmittance, that is a ratio of a light transmittance in a direction $\pm 30°$ inclined toward the first direction with respect to the third direction, is 1% or less; and an extending direction of the light transmitting portion has an angle of 1.5° or more and 20° or less, with respect to the second direction.

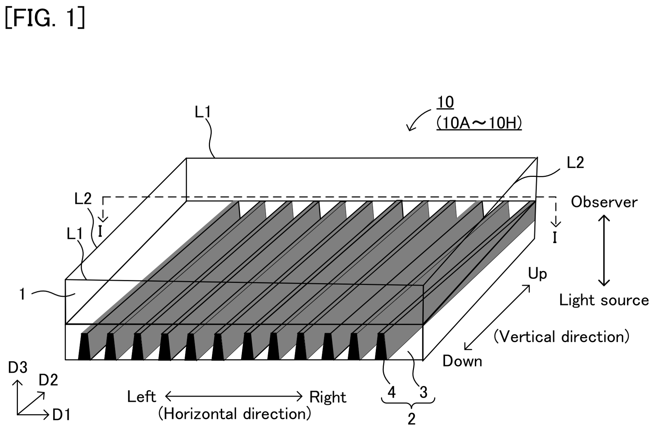

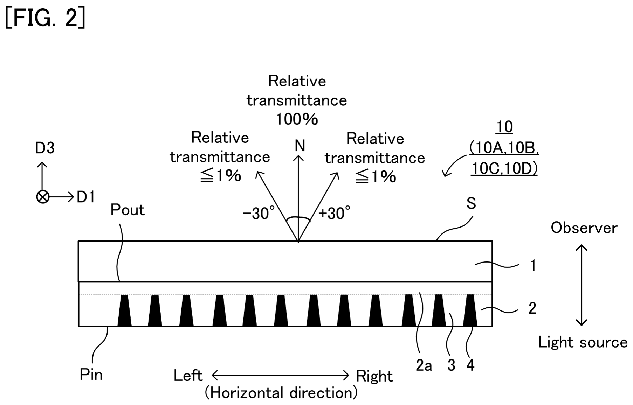

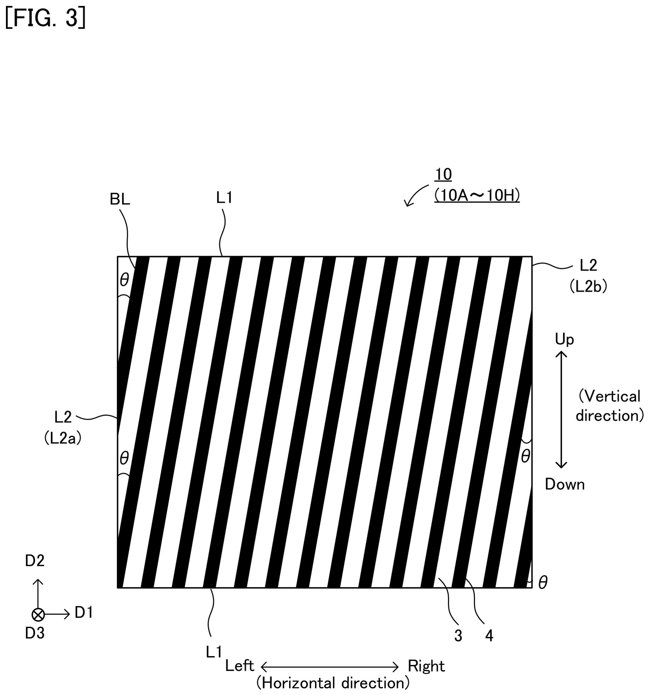

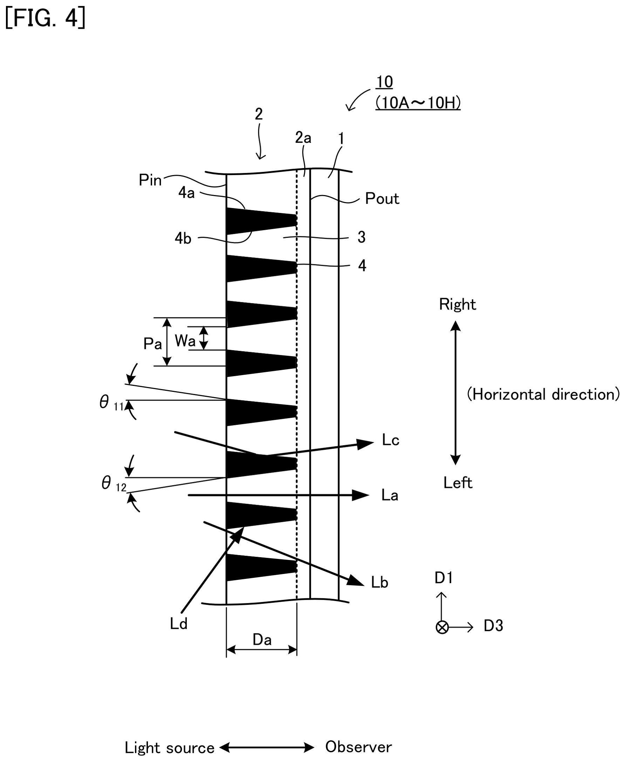

The optical sheet in the present embodiment will be explained with reference to drawings. FIG. 1 is a schematic perspective view exemplifying an optical sheet in the present embodiment. Also, FIG. 2 shows a cross-sectional view of the optical sheet cut along the line indicated by I-I in FIG. 1. FIG. 3 is a plan view of the optical sheet shown in FIG. 1, viewed along the direction from the substrate layer 1 toward the optical functional layer 2 (-D3 direction). FIG. 4 is an enlarged cross-sectional view of the optical sheet shown in FIG. 2. Incidentally, among the third direction D3, the direction from the optical functional layer 2 toward the substrate layer 1 is regarded as +D3 direction, and the direction from the substrate layer 1 toward the optical functional layer 2 is regarded as -D3 direction. Although FIG. 1 to FIG. 3 also show the orientation (vertical direction and horizontal direction), when the optical sheet is used for a display device, in the attitude which the display device is installed, the installation attitude is not limited thereto. For example, when the optical sheet is used for a display device, as shown in FIG. 1, the display device is preferably installed in such an attitude that the first direction D1 is horizontal and the second direction D2 is vertical, although not limited to this attitude. Each member is hereinafter described.

As shown in FIG. 1 to FIG., the optical sheet 10A in the present embodiment includes a substrate layer 1 in a sheet form, and an optical functional layer 2 provided on one surface of the substrate layer 1. The substrate layer 1 and the optical functional layer 2 are stacked along the third direction D3. Also, as shown in FIG. 3, in a plan view, the optical sheet 10A in the present embodiment has a rectangular shape including a pair of first sides L1 extending in a first direction D1 and a pair of second sides L2 extending in a second direction D2.

The optical functional layer 2 includes a plurality of light transmitting portions 3 having a predetermined cross-section and extending in one direction, and a light absorbing portion 4 formed between the adjacent light transmitting portions 3. As shown in FIG. 2, the cross-section of the light transmitting portion 3 cut by the D1-D3 surface is a trapezoid, and the shorter upper base is the light-incident side (light source side). In the present embodiment, as shown in FIG. 2, when a light transmittance in a third direction D3 is regarded as 100%, the relative transmittance, that is a ratio of a light transmittance in a direction $\pm 30°$ inclined toward the first direction D1 with respect to the third direction D3, is 1% or less. Further, as shown in FIG. 3, the extending direction of the light transmitting portion 3 has an angle $\theta$ of 1.5° or more and 20° or less, with respect to the second direction D2.

According to the optical sheet 10A in the present embodiment, when the light transmittance in a third direction D3 is regarded as 100%, since the relative transmittance, that is a ratio of the light transmittance in a direction $\pm 30°$ inclined toward the first direction with respect to the third direction D3, is a predetermined value or less, the light-exit angle in the first direction D1 can be controlled. Further, under a condition where the light-exit angle in the first direction D1 is controlled, when the extending direction of the light transmitting portion 3 has an angle $\theta$ of 1.5° or more and 20° or less, with respect to the second direction D2, the light-exit angle in the second direction D2 can be controlled. This is because the viewing angle in the first direction D1 is very narrow, and when this state is maintained while an angle $\theta$ of 1.5° or more and 20° or less is applied, the light transmittance in the second direction D2 decreases rapidly.

Therefore, when the optical sheet in the present embodiment is used for a display device, the light-exit angle toward lateral direction and longitudinal direction of the display device can be controlled. More specifically, when used for an optical sheet for a display device installed in front of a front passenger seat of a vehicle, the emission of image light toward the driver's side can be controlled, and the reflection of image light on the windshield in front of the front passenger seat can be controlled.

For example, controlling of the light-exit angle in the first direction D1 while controlling the light-exit angle in the second direction D2, by stacking two conventional optical sheets 90 shown in FIGS. 11 in orthogonal direction, may be considered. However, this method reduces the light transmittance so that the luminance of the display device is reduced.

In contrast to this, according to the optical sheet 10A in the present embodiment, since the light-exit angle in the first direction D1 can be controlled while controlling the light-exit angle in the second direction D2 with one optical sheet, the reduction of the light transmittance can be suppressed.

1. Optical functional layer

The optical sheet in the present embodiment includes a substrate layer, and an optical functional layer stacked on one surface of the substrate layer. When the optical sheet is used for a display device, it is disposed so that the optical functional layer is on the light source side, and the substrate layer is on the observer side.

As shown in FIG. 1, the optical functional layer 2 is a layer stacked on one surface of the substrate layer 1, and the light transmitting portion 3 and the light absorbing portion 4 are arranged alternately in the first direction D1 along the layer surface. In the cross-section shown in FIG. 2, the optical functional layer 2 includes an approximate trapezoidal light transmitting portion 3 and an approximate trapezoid cross-sectional light absorbing portion 4 formed between the two adjacent light transmitting portions 3. The light incident on the optical sheet 10A enters the optical functional layer 2 from a light-incident surface Pin, and except for a part among the light, the light exits from a light-exit surface Pout.

FIG. 4 is an enlarged view of the cross-sectional view shown in FIG. 2. As shown in FIG. 4, the light La incident on the light transmitting portion 3 of the optical functional layer 2 vertically, with an incident angle of 0°, passes straight through the inside of the light transmitting portion 3, and exits from the light-exit surface Pout. Incidentally, although not shown in the figure, the light incident on the light absorbing portion 4 of the optical functional layer 2 vertically, with an incident angle of 0°, is absorbed by the light absorbing portion 4, and is blocked by the optical functional layer 2. Among the light incident on the light transmitting portion 3 of the optical functional layer 2 at a tilt with an incident angle larger than 0°, light Lb incident on the vicinity of the boundary with the light transmitting portion 4 travels obliquely inside the light transmitting portion 3, and exits from the light-exit surface Pout, without being blocked by the light absorbing portion 4 adjacent to the light absorbing portion 4. Therefore, the light incident on the light transmitting portion 3 at an angle greater than the incident angle of this light Lb is blocked by the light absorbing portion 4, so that the total light incident on the optical functional layer 2 is controlled.

Among the light incident on the light transmitting portion 3 of the optical functional layer 2 at a tilt with an incident angle larger than 0°, at least a part of light Lc, that travels obliquely inside the light transmitting portion 3 and reaches the light absorbing portion 4 side surface, is reflected by the light absorbing portion 4 side surface, the traveling direction is changed to the front side direction, collected, and passes through the light transmitting portion 3. In this case, when the refractive index of the light absorbing portion 4 is set lower than the refractive index of the light transmitting portion 3, the light Lc that reaches the light absorbing portion 4 side surface at an incident angle of the critical angle or more is totally reflected, not being absorbed by the light absorbing portion 4. Therefore, the light transmittance is improved by the total reflection effect.

Among the light incident on the light transmitting portion 3 of the optical functional layer 2 at a tilt with an incident angle larger than 0°, a part of light Ld that travels obliquely inside the light transmitting portion 3 and reaches the light absorbing portion 4 side surface at a smaller incident angle, with respect to the side surface, than the light Lc is reflected by the light absorbing portion 4 side surface, and the rest is absorbed by the light absorbing portion 4.

The light transmitting portion 3 is a portion whose main function is to transmit light, and as shown in FIG. 2, in a cross-section, it is an element having a substantially trapezoidal cross-sectional shape with a long lower base on the substrate layer 1 side and a short upper base on the opposite side. The light transmitting portion 3 maintains the cross-section along the layer surface of the substrate layer 1, extends in one direction (direction forming angle $\theta$ with respect to the second direction D2), and is arranged at a predetermined interval in a direction (first direction D1) different from this extending direction.

In the optical sheet in the present embodiment, when the light transmittance in the third direction is regarded as 100%, the relative transmittance, that is a ratio of a light transmittance in a direction $\pm$30° inclined toward the first direction with respect to the third direction, is 1% or less. The relative transmittance of light is preferably 0.6% or less, and more preferably 0.4% or less.

Incidentally, the average value of the relative transmittance of light in a direction -30° inclined and the relative transmittance of light in a direction +30° inclined is regarded as "relative transmittance of light in a direction $\pm$30° inclined".

The relative transmittance, that is a ratio of a light transmittance in a direction $\pm$30° inclined toward the first direction with respect to the third direction, when the light transmittance in the third direction is regarded as 100%, is determined by the following method.

(Method for measuring)

Firstly, without disposing an optical sheet, the luminance of light of the planar light source alone in the third direction D3 is measured using a viewing angle property measuring device. As a planar light source, an edge light type planar light source using an LED as a light source is used. Then, a planar light source is disposed on the rear surface side (optical functional layer side) of the optical sheet, and the luminance of light transmitted through the optical sheet in the third direction D3 and the luminance of light transmitted in the direction ±30° inclined toward the first direction D1, with respect to the third direction D3, are measured with a viewing angle property measuring device on the front surface side (substrate layer side) of the optical sheet. Then, the ratio of the luminance of light transmitted through the optical sheet in the third direction D3, with respect to the luminance of light of the planar light source alone in the third direction D3, is calculated as the transmittance of light transmitted through the optical sheet in the third direction D3. Similarly, the ratio of the luminance of light transmitted in the direction ±30° inclined toward the first direction D1 with respect to the third direction D3, with respect to the luminance of light of the planar light source alone in the third direction D3, is calculated as the transmittance of light transmitted in the direction ±30° inclined toward the first direction with respect to the third direction. Finally, when the transmittance of the light transmitted through the optical sheet in the third direction D3 is regarded as 100%, the relative transmittance, that is a ratio of transmittance of the light transmitted in the direction ±30° inclined toward the first direction D1 with respect to the third direction D3, is calculated.

.

Transmittance $T_0$ of light transmitted through the optical sheet in the third direction D3 (%) = {(luminance of light emitted from the optical sheet in the third direction D3)/(luminance of light of the planar light source in the third direction D3)} × 100 (%)

.

Transmittance $T_0$ of light transmitted through the optical sheet in the third direction D3 (%) = {(luminance of light emitted from the optical sheet in the third direction D3)/(luminance of light of the planar light source in the third direction D3)} × 100 (%)

.

$$\text{Relative transmittance (\%)} = (T_{30}/T_0) \times 100\ (\%)$$

The optical sheet having such optical properties can be obtained by adjusting any one or more of, for example, the cross-sectional shape of the light absorbing portion and light transmitting portion, the refractive index of the light absorbing portion and light transmitting portion, the aperture ratio on a light-incident side, the height of the light absorbing portion, and the OD value of the light absorbing portion.

In the optical sheet in the present embodiment, when a light transmittance in the third direction is regarded as 100%, a relative transmittance, that is a ratio of a light transmittance in a direction ±20° inclined toward the first direction with respect to the third direction, is preferably 10% or less, and more preferably 5% or less.

Incidentally, the average value of the relative transmittance of light in a direction -20° inclined and the relative transmittance of light in a direction +20° inclined is regarded as "relative transmittance of light in a direction ±20° inclined".

The relative transmittance, that is a ratio of a light transmittance in a direction ±20° inclined toward the first direction with respect to the third direction, when the light transmittance in the third direction is regarded as 100%, can be determined by the method similar to the method for determining the relative transmittance, that is a ratio of a light transmittance in a direction ±30° inclined toward the first direction with respect to the third direction, when the light transmittance in the third direction D3 is regarded as 100%.

Also, in the optical sheet in the present embodiment, when the light transmittance in the third direction is regarded as 100%, the relative transmittance, that is a ratio of a light transmittance in a direction ±30° inclined toward the second direction with respect to the third direction, may be 32% or less, may be 30% or less, and may be 25% or less.

The relative transmittance, that is a ratio of a light transmittance in a direction ±30° inclined toward the second direction with respect to the third direction, when the light transmittance in the third direction is regarded as 100%, can be determined by the method similar to the method for determining the relative transmittance, that is a ratio of a light transmittance in a direction ±30° inclined toward the first direction with respect to the third direction, when the light transmittance in the third direction is regarded as 100%.

In the present embodiment, in a plan view, the extending direction of the light transmitting portion 3 has an angle θ of 1.5° or more and 20° or less, with respect to the second direction D2. The angle θ is 1.5° or more, may be 5° or more, and may be 10° or more. Meanwhile, angle θ is 20° or less, and may be 15° or less. That is, the angle θ is 1.5° or more and 20° or less, may be 5° or more and 20° or less, and may be 10° or more and 15° or less. When the angle θ is in the above range, the light-exit angle in the second direction can be controlled. Incidentally, when the display device is installed in the attitude shown in FIG. 1, the right side viewed from the observer is regarded as +D1 direction, and the left side is regarded as -D1 direction. In FIG. 1 and FIG. 3, the light transmitting portion 3 has an angle θ on the right side (+D1 side) with respect to the second direction D2. In this case, the left side (-D1 side) is preferably the driver's side. Meanwhile, the light transmitting portion 3 may have an angle θ on the left side (-D1 side) with respect to the second direction D2. In this case, the right side (+D1 side) is preferably the driver's side.

The angle θ is determined by the following method. First, as shown in FIG. 3, the optical sheet 10 is disposed so that the extending direction of the light transmitting portion 3 is longitudinal. In this case, it does not matter whether the optical sheet is vertically long or horizontally long. Then, the smaller angle, among the angles formed between the longitudinal side (L2) of the optical sheet 10 and the boundary line BL between the light transmitting portion 3 and the light absorbing portion 4 is measured. When measuring the angle, the boundary line BL between the light transmitting portion 3 and the light absorbing portion 4, on the surface of the shorter upper base of the light transmitting portion 3 and the longer lower base of the light absorbing portion 4 of the optical functional layer 2, is used. Also, as shown in FIG. 3, the above angle is measured at two locations on each of the two longitudinal sides (L2a and L2b) of the optical sheet 10, and the arithmetic average value of the four measurement values is regarded as the angle θ.

An interval (groove) having an approximate trapezoidal cross-section is formed between adjacent light transmitting portions 3. Therefore, the interval (groove) has a trapezoidal cross-section with a longer lower base on the upper base side (opposite to the substrate layer 1 side) of the light transmitting portion 3 and a shorter upper base on the lower base side (substrate layer 1 side) of the light transmitting portion 3, and the light absorbing portion 4 is formed by filling it with the necessary materials described below. Incidentally, in FIG. 1 to FIG. 4, the adjacent light transmitting portions 3 are connected by a sheet-shaped connecting portion 2a on the longer lower base side.

The refractive index of the light transmitting portion 3 is set to Nt. Such a light transmitting portion 3 can be formed by curing the composition that constitutes the light transmitting portion. Details will be explained later. The value of refractive index Nt is particularly limited, and is, for example, 1.50 or more, and preferably 1.54 or more. Meanwhile, the value of refractive index Nt is, for example, 1.65 or less, and preferably 1.60 or less. Specifically, the value of refractive index Nt is 1.50 or more and 1.65 or less, and preferably 1.54 or more and 1.60 or less. This is because the refractive index difference with respect to the light absorbing portion, which will be described later, can be easily obtained.

The light absorbing portion 4 functions as an intervening portion formed in the interval (groove) described above formed between adjacent light transmitting portions 3, and has a cross-sectional shape similar to the cross-sectional shape of the interval. Therefore, the shorter upper base faces the substrate layer 1 side, and the longer lower base faces the opposite side to the substrate layer 1. By disposing the light absorbing portion so that the shorter upper base is on the light-exit surface Pout side, a part of the light that travels through the inside of the light transmitting portion and reaches the side surface of the light absorbing portion, specifically the interface between the light absorbing portion and the light transmitting portion, can be reflected thereon so that the light can be collected toward the front direction, thereby improving light transmittance.

The refractive index of the light absorbing portion 4 is set to Nr, and is configured to absorb light. Specifically, light absorbing particles are dispersed in a transparent resin having a refractive index of Nr. The refractive index Nr is preferably less than the refractive index Nt of the light transmitting portion 3. In this way, by making the refractive index of the light absorbing portion 4 less than the refractive index of the light transmitting portion 3, the light incident on the light transmitting portion 3 under a predetermined conditions can be totally reflected properly at the interface with the light absorbing portion 4. Also, even when the total reflection condition is not satisfied, a part of the light is reflected on the interface.

The value of refractive index Nr is not particularly limited, and is, for example, 1.47 or more, and preferably 1.51 or more. Meanwhile, the value of refractive index Nr is, for example, 1.65 or less, and preferably 1.57 or less. Specifically, the value of refractive index Nr is 1.47 or more and 1.65 or less, and preferably 1.51 or more and 1.57 or less. This is because the refractive index difference with respect to the light transmitting portion, which will be described later, can be easily obtained.

The difference Nt - Nr between the refractive index Nt of the light transmitting portion 3 and the refractive index Nr of the light absorbing portion 4 is not particularly limited, and it is preferably 0.05 or less, and more preferably 0.03 or less. The difference Nt - Nr of the refractive index is, for example, 0 or more. By making the refractive index difference low, the total reflection is appropriately suppressed, and the viewing angle in the first direction (lateral direction when used as an optical sheet for the display device installed in front of a front passenger seat of a vehicle) can be controlled.

FIG. 4 shows angles $\theta_{11}$ and $\theta_{12}$ formed by an interface between the light transmitting portion 3 and the light absorbing portion 4, with respect to a normal line to a layer surface of the optical functional layer 2. The angle $\theta_{11}$ is the angle formed between the interface 4a on the right side of the light absorbing portion 4, among the interfaces between the light transmitting portion 3 and light absorbing portion 4, when optical sheet 10 is disposed with the substrate layer 1 side on the observer side; and the normal line to the layer surface of optical functional layer 2. The angle $\theta_{12}$ is the angle formed between the interface 4b on the left side of the light absorbing portion 4, among the interfaces between the light transmitting portion 3 and light absorbing portion 4 in the same attitude; and the normal line to the layer surface of optical functional layer 2.

The angle $\theta_{11}$ and the angle $\theta_{12}$ (that is, the leg inclination angles in the trapezoidal cross-section) are not particularly limited, and is, for example, 4.0° or more, and preferably 4.5° or more. By setting the angle $\theta_{11}$ and the angle $\theta_{12}$ in the above range, the viewing angle in the first direction (lateral direction when used as an optical sheet for the display device installed in front of a front passenger seat of a vehicle) can be controlled easily. Meanwhile, the angles $\theta_{11}$ and angle $\theta_{12}$ are, for example, 6.5° or less, and preferably 5.5° or less. That is, the angle $\theta_{11}$ and the angle $\theta_{12}$ are, for example, 4.0° or more and 6.5° or less, and preferably 4.5° or more and 5.5° or less.

In the present embodiment, the aperture ratio on the light-incident side is, for example, 40% or less, and preferably 35% or less. By setting the aperture ratio on the light-incident side in the above range, the viewing angle in the first direction (lateral direction when used as an optical sheet for the display device installed in front of a front passenger seat of a vehicle) can be controlled easily. Meanwhile, the aperture ratio on the light-incident side is, for example, 25% or more, and preferably 30% or more. By setting the aperture ratio on the light-incident side in the range described above, the luminance of the display device may be suppressed from decreasing. That is, the aperture ratio on the light-incident side is, for example, 25% or more and 40% or less, preferably 25% or more and 35% or less, and more preferably 30% or more and 35% or less. As shown in FIG. 4, the aperture ratio on the light-incident side is the ratio (Wa/Pa) of the width Wa of the light transmitting portion 3 existing between the light absorbing portions 4, with respect to the distance Pa between the centers of the adjacent light absorbing portions 4 on the surface opposite to the substrate layer 1 side.

The height Da of the light absorbing portion is not particularly limited, and is, for example, 110 μm or more, and preferably 120 μm or more. By setting the height Da of the light absorbing portion in the above range, the viewing angle in the first direction (lateral direction when used as an optical sheet for the display device installed in front of a front passenger seat of a vehicle) can be controlled easily. Meanwhile, the height Da of the light absorbing portion is less than or equal to the thickness of the optical functional layer, and is, for example, 140 μm or less.

The OD value (optical density value) of the light absorbing portion is not particularly limited, and is, for example, 3.5 or more, and preferably 4.0 or more. Meanwhile, the OD value of the light absorbing portion is, for example, 5.0 or less, and preferably 4.5 or less. Specifically, the OD value of the light absorbing portion is, for example, 3.5 or more and 5.0 or less, and preferably 4.0 or more and 4.5 or less.

The method for measuring the OD value of the light absorbing portion is as follows. Firstly, an easily adhesive PET film is coated with a composition for a light absorbing portion so as to be a thickness of 60 μm, laminated with an untreated PET film, and one side thereof is UV cured. Thereafter, the other side is also UV cured to prepare a measurement sample. The transmittance of this light absorbing layer is measured with a transmission densitometer, and the OD value is calculated.

Although FIG, 1 to FIG. 4 show examples where the interface between the light transmitting portion 3 and the light absorbing portion 4 is straight in the cross-section, aspects are not limited thereto, and the interface may be, for example, a polygonal line, may be a convex curved surface, and may be a concave curved surface. Also, the cross-sectional shape of the plurality of the light transmitting portions 3 and light absorbing portions 4 may be the same, and may have different cross-sectional shapes with a predetermined regularity.

2. Substrate layer

The substrate layer in the present embodiment is a flat sheet-shaped member configured to support the optical functional layer. As the substrate layer, resin substrates are used. As the material of the substrate layer, various materials can be used. For example, materials widely used as a material for optical sheets incorporated into display devices, having excellent mechanical properties, optical properties, stability and workability, and inexpensively available materials can be used. Examples of such material may include polyesters such as polyethylene terephthalate (PET), triacetylcellulose (TAC), acrylic resins, methacrylic resins, polycarbonates and cycloolefin polymers.

As will be explained later, when the optical sheet in the present embodiment is used for a liquid crystal display, the birefringence (retardation) of the substrate layer is preferably low, in consideration of the combination of the planar light source device and the lower polarizing plate. As materials having low birefringence, TAC, methacrylic resins, and polycarbonates are preferably used. In addition, polycarbonate, which has a high glass transition point, is more preferable for applications that require high heat resistance, such as automotive applications. Specifically, the glass transition point of polycarbonate is 143°C, which is suitable for automotive applications where durability at 105°C is generally required.

Meanwhile, the birefringence (retardation) of the substrate layer is also preferably high in order to suppress iridescent unevenness. As materials having high birefringence, polyesters are preferably used. Polyesters are also advantageous in cost and mechanical strength.

In view of suppressing iridescent unevenness, the retardation of the substrate layer is preferably 3000 nm or more. The upper limit of the retardation of the substrate layer is not particularly limited, and it is preferably approximately 30000 nm. When the retardation of the substrate layer is too high, the substrate layer may be considerably thick. From the viewpoint of thinning the substrate layer, the retardation of the substrate layer is more preferably 5000 nm or more and 25000 nm or less, and further preferably 7000 nm or more and 20000 nm or less.

The retardation Re of the substrate layer is expressed by the following formula, including the refractive index nx in the direction with the largest refractive index in the substrate layer surface (slow axis direction), the refractive index ny in the direction perpendicular to the slow axis direction (fast axis direction), and the thickness d of the substrate layer.

$$Re = (nx - ny) \times d$$

The retardation is measured using a phase difference measuring device. For example, a retardation measurement device "KOBRA-WR" from Oji Scientific Instruments Co., Ltd. is used as the retardation measurement device. The measurement angle is 0° and the measurement wavelength is 589.3 nm.

The above nx - ny (hereinafter referred to as $\Delta n$) is preferably 0.05 or more. When the $\Delta n$ is too low, the thickness required to obtain the retardation may become thicker. Meanwhile, the $\Delta n$ is preferably 0.25 or less. When the $\Delta n$ is too high, the substrate layer is required to be excessively stretched so that the substrate layer tends to tear or breake, and practical utility as an industrial material may be significantly reduced. Therefore, the $\Delta n$ is more preferably 0.07 or more and 0.15 or less. Incidentally, when the $\Delta n$ exceeds 0.15, the durability of the substrate layer in the moist-heat resistance test may be inferior. The $\Delta n$ is further preferably 0.12 or less, because of the excellent durability in the moist-heat resistance test.

The "nx" is preferably 1.66 or more and 1.78 or less, and more preferably 1.68 or more and 1.73 or less. Also, the "ny" is preferably 1.55 or more and 1.65 or less, and more preferably 1.57 or more and 1.62 or less. When the "nx" and "ny" are within the ranges described above and the relationship of the $\Delta n$ is satisfied, the optimal antireflection performance and the improvement of the contrast under bright light can be achieved.

Polyesters are not limited as long as they satisfy the above retardation, and examples thereof may include linear saturated polyesters synthesized from aromatic dibasic acids or their ester forming derivatives and diols or their ester forming derivatives. Specifically, examples thereof may include polyethylene terephthalate, polyethylene isophthalate, polybutylene terephthalate, poly(1,4-cyclohexylenedimethylene terephthalate), and polyethylene-2,6-naphthalate. Also, polyesters may be copolymers of these polyesters. Also, a mixture of polyester with other types of resin, including polyesters as a main component, may be used. In the mixture, the content of polyester is, for example, 80% by mole or more. In particular, because of their good balance of mechanical properties and optical properties, polyethylene terephthalate and polyethylene-2,6-naphthalate are preferable. In particular, polyethylene terephthalate (PET) is preferable. This is because PET is highly versatile and easily available. Further, PET has excellent transparency, thermal or mechanical properties: the retardation can be controlled by a stretching; has high intrinsic birefringence; and high retardation can be obtained relatively easy even the thickness is thin.

When the substrate layer is a polyester substrate, the method for producing a polyester substrate is not particularly limited as long as the above retardation is satisfied, and examples thereof may include a method wherein polyester is melted; an extruded sheet-shaped unstretched polyester is transversely stretched using a tenter at a temperature equal to or higher than the glass transition temperature; and then heat treated. The transversely stretching temperature is preferably 80°C or more and 130°C or less, and more preferably 90°C or more and 120°C or less. Also, the transverse stretching ratio is preferably 2.5 times or more and 6.0 times or less, and more preferably 3.0 times or more and 5.5 times or less. When the transverse stretching ratio is too high, the transparency of the resulting polyester substrate may be prone to decrease. Also, when the transverse stretching ratio is too low, the stretching tension is also low so that the birefringence of the resulting polyester substrate is low, and the retardation of the polyester substrate may not satisfy the above range. Also, in the method for producing the polyester substrate, the unstretched polyester may be stretched transversely under the above conditions using a biaxial stretching tester, and then stretched in the flow direction relative to the transverse stretching (hereinafter also referred to as longitudinal stretching). In this case, the longitudinal stretching ratio is preferably 2 times or less. When the longitudinal stretching ratio is too high, the $\Delta n$ may not satisfy the above preferable range. Also, the heat treatment temperature is preferably 100°C or more and 250°C or less, and more preferably 180°C or more and 245°C or less.

The retardation of the polyester substrate prepared by the above method can be controlled to be in the above range by appropriately setting the stretching ratio, stretching temperature, and thickness of the polyester substrate to be prepared. Specifically, the higher the stretching ratio is, the easier it is to obtain a high retardation, and the lower the stretching ratio is, the easier it is to obtain a low retardation. The lower the stretching temperature is, the easier it is to obtain a higher retardation, and the higher the stretching temperature is, the easier it is to obtain a lower retardation. The thicker the thickness is, the easier it is to obtain a higher retardation, and the thinner the thickness is, the easier it is to obtain a lower retardation.

The thickness of the polyester substrate is preferably 20 μm or more and 500 μm or less, more preferably 50 μm or more and 300 μm or less, and further preferably 50 μm or more and 150 μm or less. When the thickness of the polyester substrate is too thin, the retardation of the polyester substrate may not satisfy the above range. Also, when the thickness of the polyester substrate is too thin, the anisotropy of the mechanical properties becomes more noticeable so that the polyester substrate tends to tear or brake, and practical utility as an industrial material may be significantly reduced. Meanwhile when the thickness of the polyester substrate is too thick, the polyester substrate is very rigid, and the flexibility peculiar to the polymer film is reduced so that the practical utility as an industrial material may be reduced as well.

The total light transmittance of the substrate layer is preferably 80% or more, and more preferably 84% or more. The total light transmittance is measured according to JIS K7361-1:1997.

3. Other layers

The optical sheet in the present embodiment may include other layers other than the substrate layer and the optical functional layer described above. Examples of the other layer may include a hard coating layer including a roughened surface. Such a hard coating layer including a roughened surface is, for example, a rigid coating layer including a roughened surface exhibiting an arithmetic average roughness Ra according to JIS B0601:1994 of 0.1 μm or more. In the present embodiment, the arithmetic average roughness Ra of the hard coating layer is preferably 0.2 μm or more, and more preferably 0.4 μm or less. The hard coating layer, due to the roughened surface of its surface, can be made less scratched by contact with other adjacent optical members when the optical sheet is built into the display device. Also, the roughened surface of the hard coating layer suppresses optical adhesion and, consequently, it suppresses the generation of interference fringes due to optical adhesion, making it difficult to reduce optical performance. A hard coating layer including a roughened surface may be disposed on the surface of the substrate layer that is opposite to the optical functional layer side (light-exit side), and may be disposed on the surface if the optical functional layer that is opposite to the substrate layer side (light-incident side).

4. Method for producing

The optical sheet in the present embodiment can be produced, for example, as follows. Firstly, a light transmitting portion is formed on a substrate layer. In this process, a substrate sheet that functions as a substrate layer is inserted between a mold roll having a shape on the surface that can transfer the shape of the light transmitting portion and a nip roll disposed facing thereof. At this time, the mold roll and nip roll are rotated while supplying the composition for the light transmitting portion between the substrate sheet and the mold roll. Thereby, the composition for the light transmitting portion is filled into the groove (inverted shape of the light transmitting portion) corresponding to the light transmitting portion formed on the surface of the mold roll, and the composition conforms to the surface shape of the mold roll.

Examples of the composition for the light transmitting portion may include ionizing radiation curable type resins such as epoxy acrylate based, urethane acrylate based, polyether acrylate based, polyester acrylate based and polythiols.

The light for curing the composition for the light transmitting portion, filled into and sandwiched between the mold roll and the substrate sheet, is irradiated from the substrate sheet side, with a light irradiation device. Thereby, the composition can be cured so that the shape is fixed. Then, the mold release roll releases the substrate layer and the shaped light transmitting portion from the mold roll.

Then, a light absorbing portion is formed. In order to form the light absorbing portion, the composition for a light absorbing portion is firstly filled into the interval between the light transmitting portions. After that, the excess composition is scraped off with a doctor blade. The remaining composition is then cured from the light transmitting portion side so that a light absorbing portion can be formed. Examples of the method for curing may include a curing by ultraviolet irradiation and a curing by heating.

The composition for the light absorbing portion is not particularly limited, and examples thereof may include compositions wherein colored light absorbing particles are dispersed in light curable type resins such as urethane (meth) acrylate, polyester (meth)acrylate, epoxy (meth)acrylate and butadiene (meth)acrylate. Also, compositions wherein colored light absorbing particles are dispersed in thermosetting resins can also be used.

Also, instead of dispersing light absorbing particles, pigments and dyes can be used to color the entire light absorbing portion. As the light absorbing particles, colored light absorbing particles such as carbon black are preferably used. The light absorbing particles are not limited to the above, and colored particles that selectively absorb specific wavelengths can be used according to the properties of the image light. Specific examples may include metal salts such as carbon black, graphite, and black iron oxide; organic fine particles and glass beads colored with dyes and pigments. In particular, colored organic particles are preferably used in terms of cost, quality, and availability. The average particle size of the colored particles is preferably 1.0 μm or more and 20 μm or less, more preferably 1.0 μm or more and 10 μm or less, and further preferably 1.0 μm or more and 4.0 μm or less. Here, "average particle size" refers to the arithmetic average diameter of the diameters of 100 light absorbing particles measured by observing with an electron microscope.

5. Optical sheet

In a plan view, the optical sheet in the present embodiment has a rectangular shape including a pair of first sides L1 extending in a first direction and a pair of second sides L2 extending in a second direction. The first side L1 may be longer than, shorter than, or the same as the second side L2. The first direction, second direction and third direction are usually perpendicular to each other. In FIG. 1, the first side L1 is longer than the second side L2.

The use application of the optical sheet in the present embodiment is not particularly limited, and for example, it is used for display devices. Among them, the optical sheet in the present embodiment is preferably used as on-board display devices, and more preferably used for display devices installed in front of a front passenger seat of a vehicle. In the display device, the optical sheet may be installed on the observer side of the display panel, and may be included in the planar light source device in the display device.

B-1. Planar light source device (first embodiment)

The planar light source device in the present embodiment includes the optical sheet of the first embodiment described above, and a light source that emits light incident on the optical sheet.

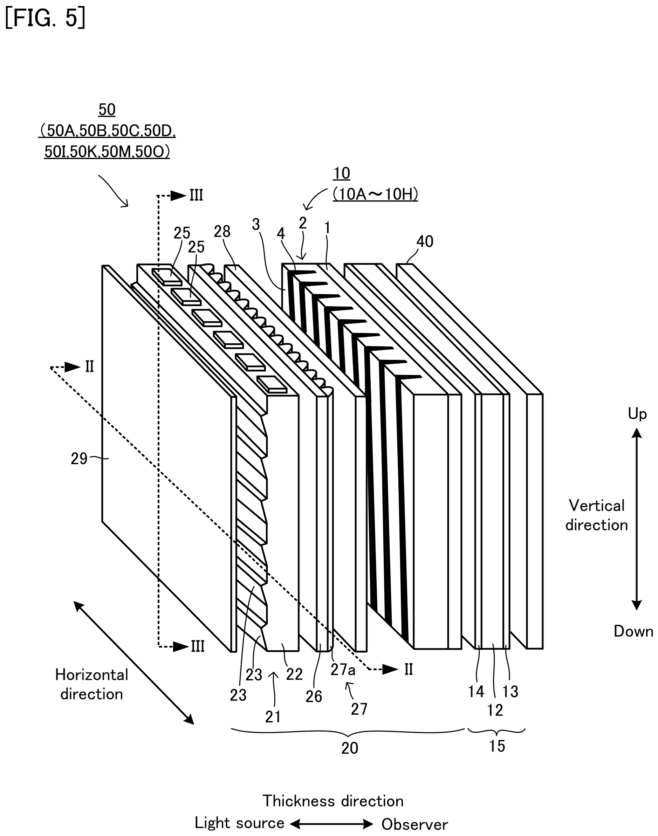

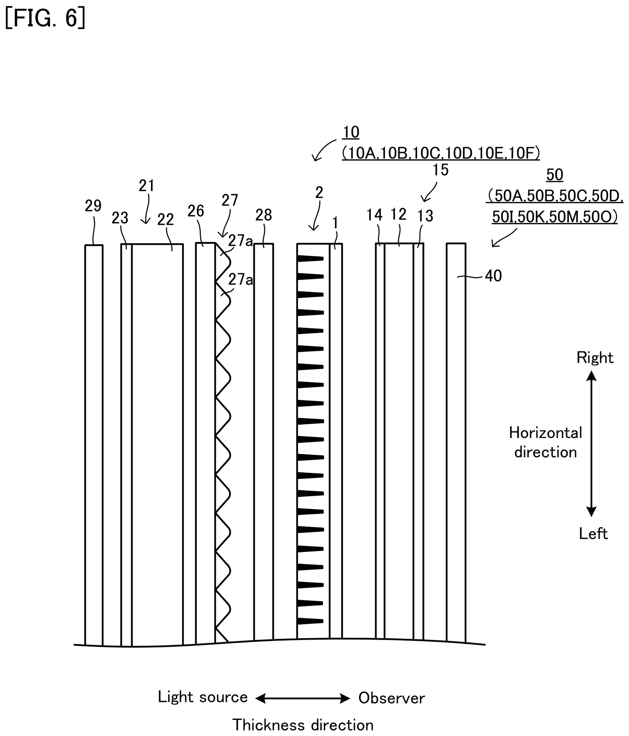

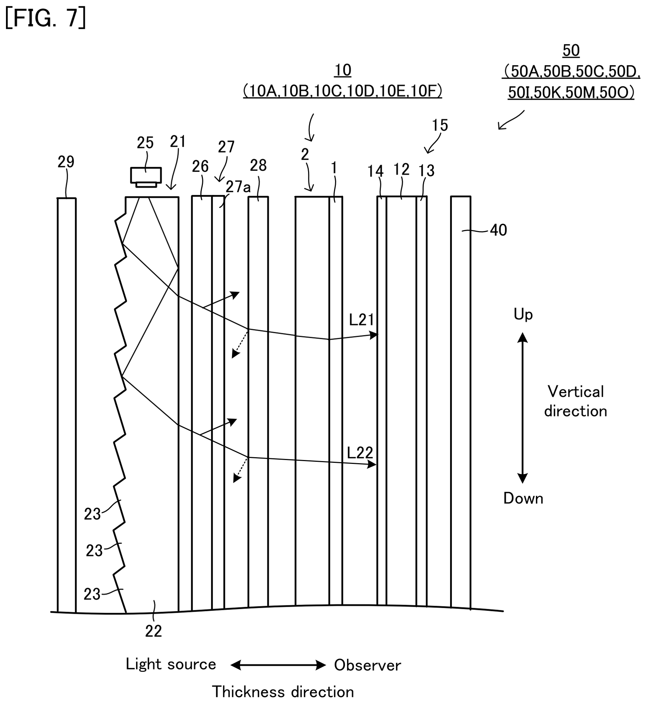

The planar light source device is usually used for display devices. FIG. 5 is an exploded perspective view exemplifying a display device provided with a planar light source device in the present embodiment. Also, FIG. 6 shows a part of the exploded cross-sectional view of the display device cut along the II-II line shown in FIG. 5, and FIG. 7 shows a part of the exploded cross-sectional view of the display device cut along the III-III line shown in FIG. 5. The display devices shown in FIG. 5 to FIG. 7 are examples of liquid crystal display devices.

As shown in FIG. 5 to FIG. 7, the display device 50A provided with a planar light source device 20 in the present embodiment is provided with a liquid crystal panel 15, a planar light source device 20, and a functional film 40. Although FIG. 5 to FIG. 7 also show the orientation in the attitudes where the display devices are installed, the installation attitudes are not limited thereto. For example, as shown in FIG. 5, the display device is preferably installed in such an attitude that the first direction D1 in FIG. 1 to FIG. 4 is horizontal and the second direction D2 is vertical, although not limited to this attitude. Each member is hereinafter described.

The planar light source device 20 in FIG. 5 to FIG. 7 includes the optical sheet 10A described above, and is located on the opposite side of the liquid crystal panel 15 from the observer side, and is an illumination device that emits planar light to the liquid crystal panel 15. Also, the planar light source device 20 in FIG. 5 to FIG. 7 is configured as an edge light type planar light source device, and includes a light guide plate 21, a light source 25, a light diffuser plate 26, a prism layer 27, a reflective type polarizing plate 28, an optical sheet 10A and a reflective sheet 29. As shown in FIG. 5 to FIG. 7, in the planar light source device 20, the optical sheet 10A is arranged so that the substrate layer 1 is on the observer side with respect to the optical functional layer 2.

As shown in FIG. 5 to FIG. 7, the light guide plate 21 includes a base portion 22 and a rear surface optical element 23. The light guide plate 21 is a plate-like member as a whole, formed by materials having translucency. As shown in FIG. 5 to FIG. 7, one plate surface side of the light guide plate 21 that is on the observer side is a smooth surface, and the other plate surface side, that is the opposite side, is considered a rear surface, and a plurality of rear surface optical elements 23 are arranged on the rear surface.

As the material of the base portion 22 and rear surface optical element 23, various materials can be used. For example, materials widely used as a material for optical sheets incorporated into display devices, having excellent mechanical properties, optical properties, stability and workability, and also inexpensively available materials can be used. Examples of such materials may include thermoplastic resins such as polymeric resins including alicyclic structures, methacrylic resins, polycarbonates, polystyrenes, acrylonitrile-styrene copolymers, methyl methacrylate-styrene copolymers, ABS resins, and polyether sulfones; epoxy acrylate and urethane acrylate based reactive resins (such as ionizing radiation curable resins).

The base portion 22 has a plate-like structure with a predetermined thickness, where light is guided inside thereof and is a portion configured to be a base for the rear surface optical element 23.

The rear surface optical element 23 is a protruding element formed on the rear surface side of the base portion 22, and has a triangular prism shape in FIG. 5 to FIG. 7. The rear surface optical element 23 has a columnar shape with the ridgeline of the protruding top portion extending horizontally, and a plurality of rear surface optical elements 23 are arranged at a predetermined pitch in a direction (vertical direction) perpendicular to the extending direction. The rear surface optical elements 23 in FIG. 5 to FIG. 7 have a triangular cross-section, and it is not limited thereto, and may have any cross-section such as a polygonal, hemispherical, partial sphere, or lens shape.

The arrangement direction of the plurality of rear surface optical elements 23 is preferably the light guiding direction. That is, the rear surface optical elements 23 are arranged in a direction away from the light source 25, and the ridgeline of each rear surface optical element 23 extends parallel to the direction in which the light sources 25 are arranged, or, if the light source is one long light source, the direction in which the light source extends.

In the present specification, the term "triangular shape" does not only refer to triangular shapes in the strict sense, but also includes approximately triangular shapes that takes into account limitations in producing technology and errors during molding. Similarly, terms used in the present specification that specify other shapes or geometric conditions, such as "parallel", "orthogonal", "ellipse", and "circle" are not to be bound by strict meanings, and are to be interpreted to include a degree of errors that allows for the expectation of similar optical functions.

The light guide plate 21 having such a configuration can be produced by extrusion molding or by molding the rear surface optical element 23 onto the base portion 22. Incidentally, in the light guide plate 21 produced by extrusion molding, the base portion 22 and the rear surface optical elements 23 can be integrally formed. Also, when the light guide plate 21 is produced by molding, the rear surface optical element 23 may or may not be of the same resin material as the base portion 22.

Among the side surfaces (end surfaces) constituting the base portion 22 of the light guide plate 21, the light source 25 is disposed on one of the side surfaces (end surfaces) in the direction in which the rear surface optical elements 23 are arranged. The light source is not particularly limited, and can be configured in various forms such as a fluorescent lamp such as a linear cold cathode tube, a point-shaped LED (light emitting diode), or an incandescent lamp. In FIG. 5 to FIG. 7, the light source 25 includes a plurality of LEDs, and is configured so that the turning on and off of each LED and/or the brightness of each LED when lit can be individually and independently adjusted by a control device not shown in the figures.

Incidentally, although FIG. 5 to FIG.7 show an example in which the light source 25 is arranged on one side surface (end surface) as described above, a configuration in which a light source is further arranged on the side surface (end surface) opposite to this side surface (end surface) may also be used. Incidentally, in this case, the shape of the rear surface optical element is also formed according to known examples.

Next, the light diffuser plate 26 will be described. The light diffuser plate 26 is a member disposed on the light-exit side of the light guide plate 21 and has the function to diffuse the incident light thereon and emit thereof. This further improves the uniformity of the light emitted from the light guide plate 21, and makes scratches on the light guide plate 21 less noticeable. As specific embodiments of the light diffuser plate, known light diffuser plates can be used, and examples thereof may include a form in which a light diffusing agent is dispersed in a base material. As shown in FIG. 5 to FIG. 7, the light diffuser plate 26 can be used as a supporting plate for the prism layer 27. Also, when the light-exit surface of the light guide plate 21 is smooth, the light diffuser plate 26 may be adhered to the light guide plate 21 to form an integral unit.

As can be seen from FIG. 5 to FIG. 7, the prism layer 27 is provided on the liquid crystal panel 15 side than the light diffuser plate 26, and is a layer including unit prisms 27a that are convex toward the liquid crystal panel 15 side. In FIG. 5 to FIG. 7, the unit prism 27a has a predetermined cross-section and extends in the light guiding direction (the vertical direction in the present aspect) of the light guide plate 21. The plurality of unit prisms 27a are arranged in a direction different from the light guiding direction (in the present aspect, a direction perpendicular to the light guiding direction in a plan view, that is, a horizontal direction).

The cross-sectional shape of the unit prism of such a prism layer can be any known shape according to the required function. The shape can further diffuse or collect the light.

Also, the direction in which the unit prisms extend and the direction in which they are arranged are not limited to the above-described aspects, and other aspects may also be used. For example, the unit prisms may have a predetermined cross-section and extend in a direction perpendicular to the light guiding direction of the light guide plate 21, and the plurality of unit prisms may be arranged in the light guiding direction.

The reflective type polarizing plate 28 has the functions to decompose the incident light into two orthogonal polarization components (P waves and S waves), transmit the polarization component (for example, P waves) in one direction (parallel to the transmission axis), and reflect the polarization component (for example, S waves) in the other direction (parallel to the reflection axis) that is orthogonal to the one direction. A known structure can be applied to such a reflective type polarizing plate.

The reflective sheet 29 of the planar light source device 20 will be described. The reflective sheet 29 is a member that reflects light emitted from the rear surface of the light guide plate 21 and causes the light to enter the light guide plate 21 again. For the reflective sheet 29, ones that allow for so-called specular reflection such as a sheet including a material having high reflectivity such as metal; and a sheet including a thin film including a material having high reflectivity (such as a metal thin film) as a surface layer can be preferably used.

C-1. Display device (first embodiment)

The display device in the present embodiment includes the optical sheet in the first embodiment described above, and a display panel. The display device is a device that displays, for example, moving images, still images, text information, or images including a combination thereof on the display panel. According to the display device in the present embodiment, the emission of image light in longitudinal direction and lateral direction can be controlled. Particularly, when the display device is installed in front of a front passenger seat of a vehicle, emission of the image light to the driver's side can be controlled, and also, the reflection of the image light on the windshield in front of the front passenger seat can be controlled.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-1-1. Display device (first example of first embodiment)

The display device in the present embodiment includes a planar light source device including the optical sheet in the first embodiment described above, and a display panel stacked on the planar light source device.

FIG. 5 to FIG. 7 are a schematic plan view and cross-sectional views exemplifying the display device in the present embodiment. Incidentally, since FIG. 5 to FIG. 7 are described in the section "B-1. Planar light source device (first embodiment)" above, the description herein is omitted.

1. Planar light source device

Since the planar light source device is described in the section "B-1. Planar light source device (first embodiment)" above, the description herein is omitted.

2. Display panel

The display panel is, for example, a liquid crystal panel. The liquid crystal panel 15 shown in FIG. 5 to FIG. 7 includes an upper polarizing plate 13 disposed on the observer side, a lower polarizing plate 14 disposed on the planar light source device 20 side, and a liquid crystal layer 12 disposed between the upper polarizing plate 13 and the lower polarizing plate 14. The upper polarizing plate 13 and the lower polarizing plate 14 have the functions to decompose the incident light into two orthogonal polarization components (P waves and S waves), transmit the polarization component (for example, P waves) in one direction (parallel to the transmission axis), and absorb the polarization component (for example, S waves) in the other direction (parallel to the absorption axis) that is orthogonal to the one direction.

In the liquid crystal layer 12, a plurality of pixels are arranged in a matrix in the direction along the layer surface, and an electric field can be applied to each region forming one pixel. And the orientation of the pixel to which the electric field is applied changes. As a result, the polarization component (for example, P wave) parallel to the transmission axis that passes through the lower polarizing plate 14 disposed on the planar light source device 20 side (that is, the light-incident side) rotates its polarization direction by 90° when passing through the pixel to which an electric field is applied, while maintaining its polarization direction when passing through the pixel to which no electric field is applied. Therefore, depending on whether or not an electric field is applied to the pixel, it is possible to control whether the polarized component (for example, P wave) that has passed through the lower polarizing plate 14 is further transmitted through the upper polarizing plate 13 disposed on the light-exit side, or is absorbed and blocked by the upper polarizing plate 13.

In this way, the liquid crystal panel 15 has a structure that controls the transmission or blocking of light from the planar light source device 20 for each pixel to display an image.

There are several types of liquid crystal panels, and the type is not particularly limited, and any known types of liquid crystal panels can be used. Specific examples thereof may include TN, STN, VA, MVA, IPS, and OCB.

3. Other components

As shown in FIG. 5 to FIG. 7, the display device in the present embodiment may include a functional film 40 disposed on the light-exit side of the liquid crystal panel 15. The functional film 40 is a member having the functions of improving the quality of image light and protecting the display device 50A. Examples of the functional film may include anti-reflection films, anti-glare films, hard coating films, color tone correction films, and light diffuser films, and these may be used alone or in a combination.

4. Operation

Next, the operation of the display device 50A having the above-described configuration will be explained, showing an example of the optical path. However, this example of the light path is a conceptual example for the purpose of explanation, and does not strictly represent the degree of reflection or refraction.

Firstly, as shown in FIG. 7, light emitted from the light source 25 enters the light guide plate 21 from the light-incident surface, which is a side surface (end surface) of the light guide plate 21. FIG. 7 shows an example of the optical paths of the light L21 and L22 incident on the light guide plate 21 from the light source 25.

As shown in FIG. 7, light L21 and L22 incident on the light guide plate 21 undergoes repeated total reflection due to the difference in refractive index with air, at the light-exit side surface of the light guide plate 21 and the rear surface on the opposite side, and travels in the light guiding direction (downward in the paper surface of FIG. 7).

However, a rear surface optical element 23 is disposed on the rear surface of the light guide plate 21. Therefore, as shown in FIG. 7, the traveling direction of light L21 and L22 traveling within the light guide plate 21 may change due to the rear surface optical element 23, and may be incident on the light-exit surface and the rear surface at an incident angle less than the critical angle of total reflection. In this case, the light may be emitted from the light-exit surface of the light guide plate 21 and the rear surface on the opposite side thereof.

The light L21 and L22 emitted from the light-exit surface travel toward the light diffuser plate 26 disposed on the light-exit side of the light guide plate 21. Meanwhile, the light emitted from the rear surface is reflected by the reflective sheet 29 disposed on the rear surface of the light guide plate 21, and enters the light guide plate 21 again to travel within the light guide plate 21.

As the light travels within the light guide plate 21, the light, whose direction is changed by the rear surface optical element 23 so as to reach the light-exit surface at an incident angle less than the critical angle of total reflection, occur in each region along the light guiding direction within the light guide plate 21. Therefore, the light traveling within the light guide plate 21 is gradually emitted from the light-exit surface. This makes it possible to make the light quantity distribution, along the light guiding direction of the light emitted from the light-exit surface of the light guide plate 21, uniform.

The light emitted from the light guide plate 21 then reaches the light diffuser plate 26, where the uniformity is improved. The light is then diffused or collected as necessary by the prism layer 27, and the light that has exited the prism layer 27 reaches the reflective type polarizing plate 28. Here, light polarized in the direction along the transmission axis of the reflective type polarizing plate 28 passes through the reflective type polarizing plate 28 and travels toward the optical sheet 10A.

Meanwhile, the light polarized in the direction along the reflection axis of the reflective type polarizing plate 28 is reflected as shown by the dotted arrow in FIG. 7, and is returned to the light guide plate 21 side. The returned light is reflected by the light guide plate 21, the rear surface optical element 23, or the reflective sheet 29, and travels toward the reflective type polarizing plate 28 again. During this reflection, the polarization direction of a part of the light is changed, and the part of this light is transmitted through the reflective type polarizing plate 28. The remaining light is returned to the light guide plate side again. In this way, the light reflected by the reflective type polarizing plate 28 can also be transmitted through the reflective type polarizing plate 28 by repeating the reflection. This increases the utilization rate of the light from the light source 25. Here, the polarization direction of the light emitted from the reflective type polarizing plate 28 is aligned with the transmission axis of the lower polarizing plate 14, and it is the polarization light which transmits through the lower polarizing plate 14.

The light emitted from the reflective type polarizing plate 28 reaches the optical sheet 10A. The light incident on the optical sheet 10A travels along the optical path described above.

The light emitted from the optical sheet 10A is incident on the lower polarizing plate 14 of the liquid crystal panel 15. The lower polarizing plate 14 transmits one polarization component, among the incident light, and absorbs the other polarization component. The light transmitted through the lower polarizing plate 14 is selectively transmitted through the upper polarizing plate 13 depending on the state of the electric field applied to each pixel. In this way, the liquid crystal panel 15 selectively transmits the light from the planar light source device 20 for each pixel, allowing the observer of the liquid crystal display device to view an image. At this time, the image light is provided to the observer via the functional film 40, improving the image quality.

5. Use application

The display device in the present embodiment is preferably used in applications wherein the emission of the image light in longitudinal direction and lateral direction is required to be controlled.

The display device in the present embodiment is preferably used as, for example, on-board display devices, and particularly preferably used for front passenger seat display devices installed in front of a front passenger seat of a vehicle.

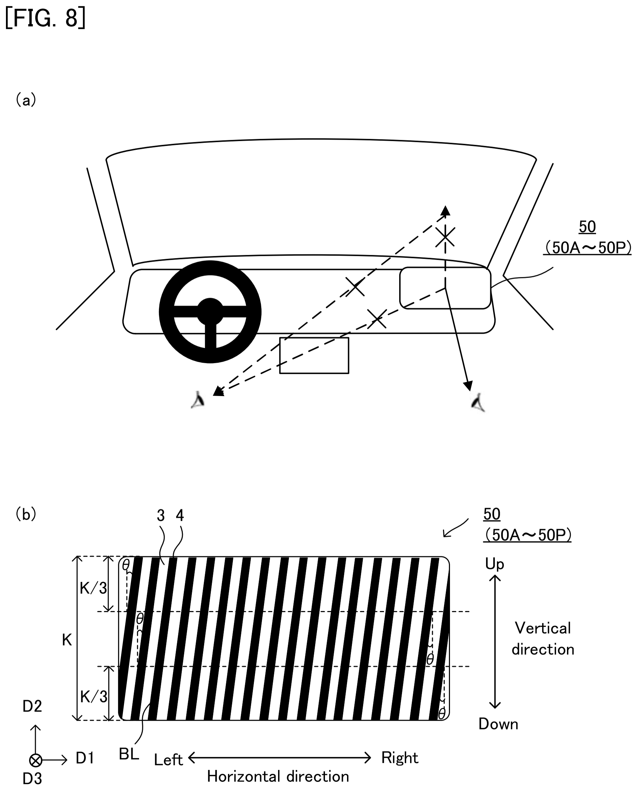

As shown in FIG. 5 to FIG. 7, in the display device 50A in the present embodiment, the substrate layer 1 in the optical sheet 10A is disposed so as to be on the observer side with respect to the optical functional layer 2. FIG. 8(a) is a schematic view of the front of inside a vehicle wherein a display device 50A in the present embodiment is installed in front of a front passenger seat of a vehicle. FIG. 8(b) is a plan view explaining the condition of the optical sheet of the display device in FIG. 8(a). In FIG. 8(a) and FIG. 8(b), the display device is disposed so that the first direction D1 of the optical sheet is horizontal direction (the lateral direction of the vehicle), and the second direction D2 is vertical direction, and the third direction D3 is horizontal direction (the front and rear direction of the vehicle). Meanwhile, the installation attitude of the display device is not limited thereto.

When the display device in the present embodiment is used as a front passenger seat display device installed in front of a front passenger seat of a vehicle, emission of the image light to the driver's side can be controlled. Also, the reflection of the image light on the windshield in front of the front passenger seat can be controlled, thereby suppressing the driver's visibility of the reflection on the windshield.

Also, the display device in the present embodiment can be used for a backseat display device installed on the ceiling of a vehicle or on a headrest. When a backseat display device is installed in each backseat, the emission of image light in lateral direction can be suppressed, and a decrease in visibility, caused by the image light from the adjacent backseat display device being reflected on the observer's backseat display device, can be suppressed. In particular, when an observer is viewing a low-luminance image on a backseat display device, and a high-luminance image is displayed on an adjacent backseat display device, the decrease in visibility can be further suppressed. Also, by suppressing the emission of image light in the upward direction, the reflection of image light on the ceiling of the backseats can be controlled, particularly at night, and to prevent the driver from seeing the reflection on the ceiling.

Also, the display device in the present embodiment can be used as a display device installed at passenger seat of, for example, buses, trains, and airplanes. In this case, the emission of the image light in lateral direction can be suppressed and privacy can be protected. Also, by suppressing the emission of image light in the upward direction, the reflection of image light on the ceiling of the passenger seats can be suppressed, particularly at night, and to prevent ones other than the observer from seeing the reflection on the ceiling.

The display device in the present embodiment can be used for various purposes, both indoors and outdoors, such as for displaying advertisements, presentations, television images, and various types of information.

C-1-2. Display device (second example of first embodiment)

The display device in the present embodiment comprises: a display panel, and the optical sheet in the first embodiment described above disposed on the observer side of the display panel.

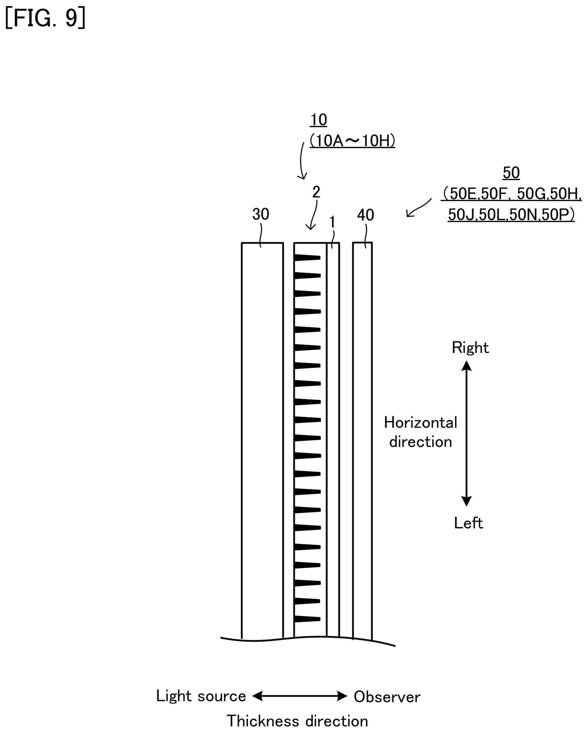

FIG. 9 is an exploded cross-sectional view exemplifying a display device in the present embodiment. As shown in FIG. 9, display device 50E in the present embodiment comprises display panel 30, and the optical sheet 10A disposed on the observer side of the display panel 30. As shown in FIG to FIG. 9, in the display device 50E, the optical sheet 10A is disposed so that the substrate layer 1 is on the observer side with respect to the optical functional layer 2. Although FIG. 9 also shows the orientation in the attitude which the display device is installed, the installation attitude is not limited thereto. For example, as shown in FIG. 9, the display device is preferably installed in such an attitude that the first direction D1 in FIG. 1 to FIG. 4 is horizontal and the second direction D2 is vertical, although not limited to this attitude.

1. Optical sheet

Since the optical sheet is described in the section "A-1. Optical sheet (first embodiment)" above, the description herein is omitted.

2. Display panel

Examples of the display panel may include liquid crystal panels and organic electroluminescence panels. The liquid crystal panel is similar to the liquid crystal panel described in the section "C-1-1. display device (first example of first embodiment)" above. For the organic electroluminescence panel, known organic electroluminescence panels can be used.

3. Other members

As shown in FIG. 9, the display device in the present embodiment may include a functional film 40 disposed on the light-exit side of the optical sheet 10A. The functional film is similar to the functional film described in the section "C-1-1. display device (first example of first embodiment)" above.

When the display panel is a liquid crystal panel, the display device in the present embodiment usually includes a planar light source device on the surface of the liquid crystal panel that is opposite to the optical sheet side. For the planar light source device, known planar light source devices can be used.

Meanwhile, when the display panel is an organic electroluminescence panel, the organic electroluminescence panel is a spontaneous luminescence type.

4. Use application

Since the use applications of the display device in the present embodiment are similar to the use applications described in the section "C-1-1. display device (first example of first embodiment)" above, the description herein is omitted.

A-2. Optical sheet (second embodiment)

As shown in FIG. 1 to FIG. 4 for example, the optical sheet 10B in the present embodiment includes a substrate layer 1, and an optical functional layer 2 stacked on one surface of the substrate layer 1. In a plan view, the optical sheet 10B in the present embodiment has a rectangular shape including a pair of first sides L1 extending in a first direction and a pair of second sides L2 extending in a second direction. The optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. The optical sheet 10B is an optical sheet for a display device installed in front of a front passenger seat of a vehicle, and the extending direction of the light transmitting portion 3 has an angle of 1.5° or more and 20° or less, with respect to the second direction D2.
Since details of FIG. 1 to FIG. 4 are described in the section "A-1. Optical sheet (first embodiment)" above, the description herein is omitted.
Since the optical sheet in the present embodiment includes an optical functional layer including a light transmitting portion having a predetermined cross-section and extending in a predetermined direction, and a light absorbing portion, the light transmittance, in a direction $\pm 30°$ inclined toward the first direction with respect to the third direction, can be reduced. Specifically, when a light transmittance in a third direction is regarded as 100%, a relative transmittance, that is a ratio of a light transmittance in a direction $\pm 30°$ inclined toward the first direction with respect to the third direction, can be made 1% or less.
Further, under a condition where the light-exit angle in the first direction D1 is controlled, when the extending direction of the light transmitting portion 3 has an angle $\theta$ of 1.5° or more and 20° or less, with respect to the second direction, the light-exit angle in the second direction D2 can be controlled.
Therefore, when the optical sheet in the present embodiment is used for a display device, the light-exit angle toward longitudinal direction and lateral direction of the display device can be controlled. More specifically, when used as an optical sheet for a display device installed in front of a front passenger seat of a vehicle, the emission of image light toward the driver's side can be controlled, and the reflection of image light on the windshield in front of the front passenger seat can be controlled.
The optical sheet in the present embodiment is an optical sheet for a display device installed in front of a front passenger seat of a vehicle.
Since other properties of the optical sheet in the present embodiment are similar to those described in the section "A-1. Optical sheet (first embodiment)" above, descriptions thereof is omitted herein.

B-2. Planar light source device (second embodiment)

As shown in FIG. 5 to FIG. 7 for example, the planar light source device 20 in the present embodiment includes the optical sheet 10B in the second embodiment described above, and a light source 25 that emits light incident on the optical sheet 10B. The planar light source device in the present embodiment is used for a front passenger seat display device.
Since details of FIG. 5 to FIG. 7 are described in the section "B-1. Planar light source device (first embodiment)" above, the description herein is omitted.
Since other members of the light source and planar light source device are described in the section "B-1. Planar light source device (first embodiment)" above, the description herein is omitted.

C-2. Display device (second embodiment)

The display device in the present embodiment includes the optical sheet in the second embodiment described above, and a display panel. According to the display device in the present embodiment, when used as a display device installed in front of a front passenger seat of a vehicle, the emission of image light toward the driver's side can be controlled, and the reflection of image light on the windshield in front of the front passenger seat can be controlled.
The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-2-1. Display device (first example of second embodiment)

The display device in the present embodiment includes a planar light source device including the optical sheet described above, and a display panel stacked on the planar light source device.
FIG. 5 to FIG. 7 are a schematic plan view and cross-sectional views exemplifying the display device in the present embodiment. Since FIG. 5 to FIG. 7 are described in the section "B-1. Planar light source device (first embodiment)" above, the description herein is omitted. As shown in FIG. 5 to FIG. 7, in the display device 50B in the present embodiment, the substrate layer 1 in the optical sheet 10B is disposed so as to be on the observer (front passenger seat) side with respect to the optical functional layer 2.

1. Planar light source device

Since the planar light source device is described in the section "B-2. Planar light source device (second embodiment)" above, the description herein is omitted.

2. Display panel and other members

Since the display panel and other members are described in the section "C-1-1. display device (first example of first embodiment)" above, the description herein is omitted.

3. Use application

The display device in the present embodiment is used as a display device installed in front of a front passenger seat of a vehicle. FIG. 8(a) is a schematic view of the front of inside a vehicle wherein a display device 50B in the present embodiment is installed in front of a front passenger seat of a vehicle. FIG. 8(b) is a plan view explaining the condition of the optical sheet of the display device 50B in FIG. 8(a). In FIG. 8(a) and FIG. 8(b), the display device is disposed so that the first direction D1 of the optical sheet is horizontal direction (the lateral direction of the vehicle), and the second direction D2 is vertical direction, and the third direction D3 is horizontal direction (the front and rear direction of the vehicle). Meanwhile, the installation attitude of the display device is not limited thereto.

C-2-2. Display device (second example of second embodiment)

The display device in the present embodiment comprises: a display panel, and the optical sheet in the second embodiment described above disposed on the observer side of the display panel.

FIG. 9 is an exploded cross-sectional view exemplifying a display device 50F in the present embodiment. Since FIG. 9 is described in the section "C-1-2. Display device (second example of first embodiment)" above, the description herein is omitted. As shown in FIG to FIG. 9, in the display device 50F in the present embodiment, the substrate layer 1 in the optical sheet 10B is disposed so as to be on the observer (front passenger seat) side with respect to the optical functional layer 2.

1. Optical sheet

Since the optical sheet is described in the section "A-2. Optical sheet (second embodiment)" above, the description herein is omitted.

2. Display panel and other members

Since the display panel and other members are described in the section "C-1-2. Display device (second example of first embodiment)" above, the description herein is omitted.

4. Use application

The display device in the present embodiment is used as a display device installed in front of a front passenger seat of a vehicle. Since the use applications of the display device in the present embodiment are similar to the use applications described in the section "C-1-2. Display device (second example of first embodiment)" above, the description herein is omitted.

C-3. Display device (third embodiment)

The display device in the present embodiment is a display device comprising an optical sheet and a display panel, wherein the optical sheet includes a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed, when a light transmittance in a normal line direction to a main surface of the optical sheet is regarded as 100%, a relative transmittance, that is a ratio of a light transmittance in a direction ±30° inclined laterally to the normal line direction, is 1% or less; and an extending direction of the light transmitting portion, viewed from the normal line direction, has an angle of 1.5° or more and 20° or less, with respect to a vertical direction.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-3-1. Display device (first example of third embodiment)

FIG. 5 to FIG. 7 are a schematic plan view and cross-sectional views exemplifying a display device in the present embodiment. Also, FIG. 1 to FIG. 4 are a schematic perspective view, cross-sectional views, and a plan view exemplifying an optical sheet in a display device in the present embodiment. As shown in FIG. 5 to FIG. 7, the display device 50C in the present embodiment includes a planar light source device 20 including the optical sheet 10C, and a liquid crystal panel 15 stacked on the planar light source device 20. As shown in FIG. 1 to FIG. 4, the optical sheet 10C in the present embodiment includes a substrate layer 1 and an optical functional layer 2 stacked on one surface of the substrate layer 1, and the optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. As shown in FIG. 2, in the optical sheet 10C, when the display device 50C is installed, and when a light transmittance in a normal line direction N (third directionD3 in FIG. 1 to FIG. 4) to a main surface S of the optical sheet is regarded as 100%, a relative transmittance, that is a ratio of a light transmittance in a direction ±30° inclined laterally to the normal line N, is 1% or less. Also, as shown in FIG. 3, in the optical sheet 10C, when the display device 50C is installed, an extending direction of the light transmitting portion 3, viewed from the normal line direction N, has an angle of 1.5° or more and 20° or less, with respect to a vertical direction.

Since details of FIG. 1 to FIG. 4 are described in the section "A-1. Optical sheet (first embodiment)" above, the description herein is omitted. Also, since FIG. 5 to FIG. 7 are described in the section "B-1. Planar light source device (first embodiment)" above, the description herein is omitted.

The display device 50C in the present embodiment includes a predetermined optical sheet 10C. According to the optical sheet 10C in the present embodiment, when the display device is installed, since the relative transmittance, that is a ratio of a light transmittance in a direction ±30° inclined toward the lateral direction with respect to the normal line direction, is a predetermined value or less, the light-exit angle in the lateral direction of the display device can be controlled. Further, under a condition where the light-exit angle in the lateral direction is controlled, when the extending direction of the light transmitting portion, viewed from the normal line direction, has an angle θ of a predetermined range, with respect to the vertical direction, the light-exit angle in the longitudinal direction of the display device can be controlled.

Therefore, with the display device, the light-exit angle toward longitudinal direction and lateral direction can be controlled. More specifically, when installed in front of a front passenger seat of a vehicle, the emission of image light toward the driver's side can be controlled, and the reflection of image light on the windshield in front of the front passenger seat can be controlled.

1. Planar light source device

The planar light source device includes a predetermined optical sheet. As shown in FIG. 1 to FIG. 4, in the optical sheet 10C in the present embodiment, when the display device is installed, and when a light transmittance in a normal line direction N (third direction D3 in FIG. 1 to FIG. 4) to a main surface of the optical sheet is regarded as 100%, a relative transmittance, that is a ratio of a light transmittance in a direction ±30° inclined laterally to the normal line direction N, is 1% or less. The relative transmittance of light is preferably 0.6% or less, and more preferably 0.4% or less.

In the optical sheet in the present embodiment, when a light transmittance in the normal line direction is regarded as 100%, a relative transmittance, that is a ratio of a light transmittance in a direction ±20° inclined toward the lateral direction with respect to the normal line direction, is preferably 10% or less, and more preferably 5% or less.

Further, in the optical sheet in the present embodiment, when the display device is installed, an extending direction of the light transmitting portion, viewed from the normal line direction, has an angle of 1.5° or more and 20° or less, with respect to a vertical direction. The angle θ is 1.5° or more, may be 5° or more, and may be 10° or more. Meanwhile, angle θ is 20° or less, and may be 15° or less. That is, the angle θ is 1.5° or more and 20° or less, may be 5° or more and 20° or less, and may be 10° or more and 15° or less. When the angle θ is in the above range, the light-exit angle in the lateral direction can be controlled. Incidentally, in FIG. 1 and FIG. 3, the light transmitting portion 3 has an angle θ on the right side (+D1 side) with respect to the vertical direction. In this case, the left side (-D1 side) is preferably the driver's side. Meanwhile light transmitting portion 3 may have an angle θ on the left side (-D1 side) with respect to the second direction D2. In this case, the right side (+D1 side) is preferably the driver's side.

The angle θ is determined by the following method. Firstly, as shown in FIG. 8(a) and FIG. 8(b), the display device 50 is installed. In this case, it does not matter whether the optical sheet of the display device 50 is vertically long or horizontally long. Then, when viewed from the normal line direction to the main surface of the optical sheet (the third direction D3 in FIG. 8(b)), that is, when an observer (for example, front passenger seat) observes the display device 50 from the front, the smaller angle, among the angles formed between the vertical line (straight line in the gravity direction) and the boundary line BL between the light transmitting portion 3 and the light absorbing portion 4, is measured. When measuring the angle, the boundary line BL between the light transmitting portion 3 and the light absorbing portion 4, on the surface of the shorter upper base of the light transmitting portion 3 and the longer lower base of the light absorbing portion 4 of the optical functional layer 2, is used. Also, as shown in FIG. 8(b), the above angle is measured at two locations of the left side and right side of the display device 50 respectively, and the arithmetic average value of the four measurement values is regarded as the angle θ. The above two locations are: a location at 1/3 of the vertical length K of the display device 50 from the top side of the display device 50; and a location at 1/3 of the vertical length K of the display device 50 from the bottom side of the display device 50.

Since the properties of the optical sheet having the optical properties described above and other properties in the present embodiment are similar to those described in the section "A-1. Optical sheet (first embodiment)" above, descriptions thereof is omitted herein. Since other members of the planar light source device are described in the section "B-1. Planar light source device (first embodiment)" above, the description herein is omitted.

2. Display panel and other members

Since the display panel and other members are described in the section "C-1-1. Display device (first example of first embodiment)" above, the description herein is omitted.

3. Use application

Since the use applications of the display device in the present embodiment are similar to those described in the section "C-1-1. Display device (first example of first embodiment)" described above, the description herein is omitted.

C-3-2. Display device (second example of third embodiment)

FIG 9 is a schematic plan view and a cross-sectional view exemplifying the display device in the present embodiment. Also, FIG. 1 to FIG. 4 are a schematic perspective view, cross-sectional views, and a plan view exemplifying an optical sheet in a display device in the present embodiment. As shown in FIG. 9, the display device 50G in the present embodiment comprises display panel 30, and the optical sheet 10C disposed on the observer side of the display panel 30. As shown in FIG. 1 to FIG. 4, the optical sheet 10C in the present embodiment includes a substrate layer 1 and an optical functional layer 2 stacked on one surface of the substrate layer 1, and the optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. As shown in FIG. 2, in the optical sheet 10C, when the display device 50G is installed, and when a light transmittance in a normal line direction N (third direction D3 in FIG. 1 to FIG. 4) to a main surface S of the optical sheet is regarded as 100%, a relative transmittance, that is a ratio of a light transmittance in a direction ±30° inclined laterally to the normal line N, is 1% or less. Also, as shown in FIG. 3, in the optical sheet 10C, when the display device 50G is installed, an extending direction of the light transmitting portion 3, viewed from the normal line direction N, has an angle of 1.5° or more and 20° or less, with respect to a vertical direction.

Since details of FIG. 1 to FIG. 4 are described in the section "A-1. Optical sheet (first embodiment)" above, the description herein is omitted. Also, since FIG. 9 is described in the section "C-1-2. Display device (second example of first embodiment)" above, the description herein is omitted.

1. Optical sheet

Since the optical sheet is similar to the optical sheet described in the section "C-3-1. Display device (first example of third embodiment)" above, the description herein is omitted.

2. Display panel and other members

Since the display panel and other members are described in the section "C-1-2. Display device (second example of first embodiment)" above, the description herein is omitted.

3. Use application

Since the use applications of the display device in the present embodiment are similar to those described in the section "C-1-1. Display device (first example of first embodiment)" above, the description herein is omitted.

C-4. Display device (fourth embodiment)

The display device in the present embodiment is a display device comprising an optical sheet and a display panel, wherein the display device is installed in front of a front passenger seat of a vehicle; the optical sheet includes a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed in front of a front passenger seat of a vehicle, an extending direction of the light transmitting portion, viewed from the normal line direction to a main surface of the optical sheet, has an angle of 1.5° or more and 20° or less, with respect to a vertical direction.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-4-1. Display device (first example of fourth embodiment)

FIG. 5 to FIG. 7 are a schematic plan view and cross-sectional views exemplifying a display device in the present embodiment. Also, FIG. 1 to FIG. 4 are a schematic perspective view, cross-sectional views, and a plan view exemplifying an optical sheet in a display device in the present embodiment. As shown in FIG. 5 to FIG. 7, the display device 50D in the present embodiment includes a planar light source device 20 including the optical sheet 10D, and a liquid crystal panel 15 stacked on the planar light source device 20, and is a display device installed in front of a front passenger seat of a vehicle. As shown in FIG. 1 to FIG. 4, the optical sheet 10D in the present embodiment includes a substrate layer 1 and an optical functional layer 2 stacked on one surface of the substrate layer 1, and the optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. In the optical sheet 10D, when the display device is installed in front of a front passenger seat of a vehicle, an extending direction of the light transmitting portion 3, viewed from the normal line direction N to the main surface of the optical sheet 10D (third direction D3 in FIG. 1 to FIG. 4), has an angle of 1.5° or more and 20° or less, with respect to a vertical direction.

The display device 50D in the present embodiment includes a predetermined optical sheet 10D. Since the optical sheet 10D in the present embodiment includes an optical functional layer including a light transmitting portion having a predetermined cross-section and extending in a predetermined direction, and a light absorbing portion, when the display device is installed in front of a front passenger seat of a vehicle, the light transmittance, in a direction ±30° inclined laterally to the normal line direction, can be reduced. Specifically, when the light transmittance in the normal line direction is regarded as 100%, a relative transmittance, that is a ratio of a light transmittance in the direction ±30° inclined toward the lateral direction with respect to the normal line direction, can be made 1% or less. Therefore, the light-exit angle of the display device in lateral direction can be controlled.

Further, under a condition where the light-exit angle in the lateral direction is controlled, when the extending direction of the light transmitting portion, viewed from the normal line direction, has an angle $\theta$ in a predetermined range, with respect to the vertical direction, the light-exit angle in the longitudinal direction of the display device can be controlled. Therefore, in the display device in the present embodiment, the emission of image light toward the driver's side can be controlled, and the reflection of image light on the windshield in front of the front passenger seat can be controlled.

1. Planar light source device

The planar light source device includes a predetermined optical sheet. The optical sheet 10D in the present embodiment includes an optical functional layer including a light transmitting portion having a predetermined cross-section and extending in a predetermined direction, and a light absorbing portion. Thereby, when the display device 50D including the predetermined optical sheet 10D is installed in front of a front passenger seat of a vehicle, and when a light transmittance in a normal line direction N (third direction D3 in FIG. 1 to FIG. 4) to a main surface of the optical sheet 10D is regarded as 100%, a relative transmittance, that is a ratio of a light transmittance in a direction ±30° inclined laterally to the normal line direction N, can be made 1% or less. The relative transmittance of light is preferably 0.6% or less, and more preferably 0.4% or less.

In the optical sheet in the present embodiment, when the light transmittance in the normal line direction is regarded as 100%, the relative transmittance, that is the ratio of the light transmittance in a direction ±20° inclined toward the lateral direction with respect to the normal line direction, is preferably 10% or less, and more preferably 5% or less.

Further, in the optical sheet in the present embodiment, when the display device is installed in front of a front passenger seat of a vehicle, the extending direction of the light transmitting portion, viewed from the normal line direction, has an angle of 1.5° or more and 20° or less, with respect to the vertical direction. The angle θ is 1.5° or more, may be 5° or more, and may be 10° or more. Meanwhile, angle θ is 20° or less, and may be 15° or less. That is, the angle θ is 1.5° or more and 20° or less, may be 5° or more and 20° or less, and may be 10° or more and 15° or less. When the angle θ is in the above range, the light-exit angle in the lateral direction can be controlled. Incidentally, in FIG. 1 and FIG. 3, the light transmitting portion 3 has the angle θ on the right side (+D1 side) with respect to the vertical direction. In this case, the left side (-D1 side) is preferably the driver's side. Meanwhile the light transmitting portion 3 may have the angle θ on the left side (-D1 side) with respect to the vertical direction. In this case, the right side (+D1 side) is preferably the driver's side.

Since other properties of the optical sheet in the present embodiment are similar to those described in the section "A-1. Optical sheet (first embodiment)" described above, description thereof is omitted herein. Since other members of the planar light source device are described in the section "B-1. Planar light source device (first embodiment)" above, the description herein is omitted.

2. Display panel and other members

Since the display panel and other members are described in the section "C-1-1. Display device (first example of first embodiment)" above, the description herein is omitted.

3. Use application

The display device in the present embodiment is installed in front of a front passenger seat of a vehicle. FIG. 8(a) is a schematic view of the front of inside a vehicle when a display device 50D in the present embodiment is installed in front of a front passenger seat of a vehicle. FIG. 8(b) is a plan view explaining the condition of the optical sheet of the display device in FIG. 8(a). In FIG. 8(a) and FIG. 8(b), the display device is disposed so that the lateral direction of the optical sheet is horizontal direction (the lateral direction of the vehicle), and the longitudinal direction is vertical direction, and the thickness direction is horizontal direction (the front and rear direction of the vehicle). Meanwhile, the installation attitude of the display device is not limited thereto.

C-4-2. Display device (second example of fourth embodiment)

FIG 9 is a schematic plan view and a cross-sectional view exemplifying a display device in the present embodiment. Also, FIG. 1 to FIG. 4 are a schematic perspective view, cross-sectional views, and a plan view exemplifying an optical sheet in a display device in the present embodiment. As shown in FIG. 9, the display device 50H in the present embodiment is a display device comprising a display panel 30, and an optical sheet 10D disposed on the observer side of the display panel 30, and is installed in front of a front passenger seat of a vehicle. As shown in FIG. 1 to FIG. 4, the optical sheet 10D in the present embodiment includes a substrate layer 1 and an optical functional layer 2 stacked on one surface of the substrate layer 1, and the optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. In the optical sheet 10D, when the display device is installed in front of a front passenger seat of a vehicle, an extending direction of the light transmitting portion 3, viewed from the normal line direction N to the main surface of the optical sheet 10D (third direction D3 in FIG. 1 to FIG. 4), has an angle of 1.5° or more and 20° or less, with respect to a vertical direction.

The display device 50D in the present embodiment includes a predetermined optical sheet 10D. Since the optical sheet 10D in the present embodiment includes an optical functional layer including a light transmitting portion having a predetermined cross-section and extending in a predetermined direction, and a light absorbing portion, when the display device is installed in front of a front passenger seat of a vehicle, the light transmittance, in the direction ±30° inclined laterally to the normal line direction, can be reduced. Specifically, when a light transmittance in the normal line direction is regarded as 100%, the relative transmittance, that is the ratio of the light transmittance in a direction ±30° inclined toward the lateral direction with respect to the normal line direction, can be made 1% or less. Therefore, the light-exit angle of the display device in lateral direction can be controlled.

Further, under a condition where the light-exit angle in the lateral direction is controlled, when the extending direction of the light transmitting portion, viewed from the normal line direction, has an angle θ of a predetermined range, with respect to the vertical direction, the light-exit angle in the longitudinal direction of the display device can be controlled. Therefore, in the display device in the present embodiment, the emission of image light toward the driver's side can be controlled, and the reflection of image light on the windshield in front of the front passenger seat can be controlled.

1. Optical sheet

The optical sheet is similar to the optical sheet described in the section "C-4-2. Display device (second example of fourth embodiment)" above.

2. Display panel and other members

Since the display panel and other members are described in the section "C-1-1. Display device (first example of first embodiment)" above, the description herein is omitted.

3. Use application

The use applications of the display device in the present embodiment are similar to those described in the section "C-1-1. Display device (first example of first embodiment)" above.

A-3. Optical sheet (fifth embodiment)

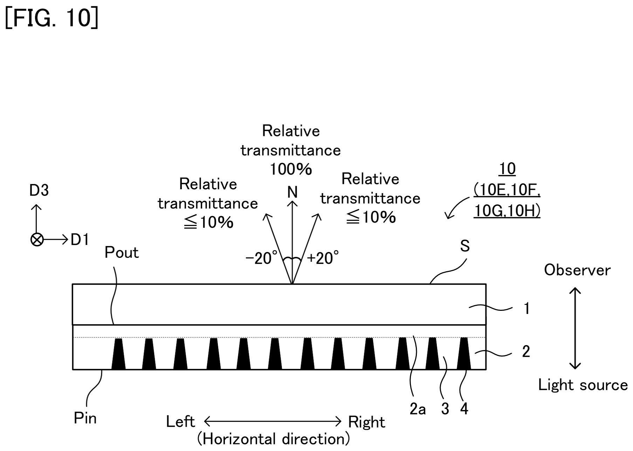

FIG. 1 is a schematic perspective view exemplifying an optical sheet in the present embodiment. Also, FIG. 10 shows a cross-sectional view of the optical sheet cut along the line indicated by I-I in FIG. 1. FIG. 3 is a plan view of the optical sheet shown in FIG. 1, viewed along the direction from the substrate layer 1 toward the optical functional layer 2 (-D3 direction). FIG. 4 is an enlarged cross-sectional view of the optical sheet shown in FIG. 10. As shown in FIG. 1, FIG. 3, FIG. 4 and FIG. 10, the optical sheet 10E in the present embodiment includes a substrate layer 1, and an optical functional layer 2 stacked on one surface of the substrate layer 1. In a plan view, the optical sheet 10E in the present embodiment has a rectangular shape including a pair of first sides L1 extending in the first direction D1 and a pair of second sides L2 extending in the second direction D2. The optical functional layer 2 includes a plurality of light transmitting portions 3 having a predetermined cross-section and extending in one direction, and a light absorbing portion 4 formed between the adjacent light transmitting portions 3. As shown in FIG. 10, the cross-section of the light transmitting portion 3 is a trapezoid, and the short upper base is the light-incident side (light source side). In the present embodiment, as shown in FIG. 10, when the light transmittance in the third direction D3 is regarded as 100%, the relative transmittance, that is the ratio of the light transmittance in the direction ±20° inclined toward the first direction D1 with respect to the third direction D3, is 10% or less. Further, as shown in FIG. 3, the extending direction of the light transmitting portion 3 has an angle θ of 1.5° or more and 20° or less, with respect to the second direction D2.

According to the optical sheet 10A in the present embodiment, when the light transmittance in the third direction D3 is regarded as 100%, since the relative transmittance, that is the ratio of the light transmittance in the direction ±20° inclined toward the first direction with respect to the third direction D3, is a predetermined value or less, the light-exit angle in the first direction D1 can be controlled. Further, under a condition where the light-exit angle in the first direction D1 is controlled, when the extending direction of the light transmitting portion 3 has an angle θ of 1.5° or more and 20° or less, with respect to the second direction D2, the light-exit angle in the second direction D2 can be controlled. This is because the viewing angle in the first direction D1 is very narrow, and when this state is maintained while an angle θ of 1.5° or more and 20° or less is applied, the light transmittance in the second direction D2 decreases rapidly.

Therefore, when the optical sheet in the present embodiment is used as a display device, the light-exit angle toward longitudinal direction and lateral direction of the display device can be controlled. More specifically, when used as an optical sheet for a display device installed in front of a front passenger seat of a vehicle, the emission of image light toward the driver's side can be controlled, and the reflection of image light on the windshield can be controlled.

Since other properties of the optical sheet in the present embodiment are similar to those described in the section "A-1. Optical sheet (first embodiment)" above, descriptions thereof is omitted herein.

B-3. Planar light source device (fifth embodiment)

As shown in FIG. 5 to FIG. 7 for example, the planar light source device 20 in the present embodiment includes the optical sheet 10E in the fifth embodiment described above, and a light source 25 that emits light incident on the optical sheet 10E.

Since details of FIG. 5 to FIG. 7 are described in the section "B-1. Planar light source device (first embodiment)" above, the description herein is omitted.

Since other members of the light source and planar light source device are described in the section "B-1. Planar light source device (first embodiment)" above, the description herein is omitted.

C-5. Display device (fifth embodiment)

The display device in the present embodiment includes the optical sheet in the fifth embodiment described above, and a display panel.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-5-1. Display device (first example of fifth embodiment)

The display device in the present embodiment includes a planar light source device including the optical sheet in the fifth embodiment described above, and a display panel stacked on the planar light source device.

FIG. 5 to FIG. 7 are a schematic plan view and cross-sectional views exemplifying the display device 50I in the present embodiment. Since FIG. 5 to FIG. 7 are described in the section "B-1. Planar light source device (first embodiment)" above, the description herein is omitted.

1. Planar light source device

Since the planar light source device is described in the section "B-3. Planar light source device (fifth embodiment)" above, the description herein is omitted.

2. Display panel and other members

Since the display panel and other members are described in the section "C-1-1. Display device (first example of first embodiment)" above, the description herein is omitted.

3. Use application

Since the use applications of the display device in the present embodiment are similar to the use applications described in the section "C-1-1. Display device (first example of first embodiment)" above, the description herein is omitted.

C-5-2. Display device (second example of fifth embodiment)

The display device in the present embodiment comprises a display panel, and the optical sheet in the fifth embodiment described above disposed on the observer side of the display panel.

FIG 9 is a schematic plan view and a cross-sectional view exemplifying the display device 50J in the present embodiment. Since FIG. 9 is described in the section "C-1-2. Display device (second example of first embodiment)" above, the description herein is omitted. As shown in FIG to FIG. 9, in the display device 50J in the present embodiment, the substrate layer 1 in the optical sheet 10I is disposed so as to be on the observer (front passenger seat) side with respect to the optical functional layer 2.

1. Optical sheet

Since the optical sheet is described in the section "A-3. Optical sheet (fifth embodiment)" above, the description herein is omitted.

2. Display panel and other members

Since the display panel and other members are described in the section "C-1-2. Display device (second example of first embodiment)" above, the description herein is omitted.

3. Use application

Since the use applications of the display device in the present embodiment are similar to the use applications described in the section "C-1-1. Display device (first example of first embodiment)" above, the description herein is omitted.

A-4. Optical sheet (sixth embodiment)

As shown in FIG. 1, FIG. 3, FIG. 4 and FIG. 10 for example, the optical sheet 10F in the present embodiment includes a substrate layer 1, and an optical functional layer 2 stacked on one surface of the substrate layer 1. In a plan view, the optical sheet 10F in the present embodiment has a rectangular shape including a pair of first sides L1 extending in the first direction and a pair of second sides L2 extending in the second direction. The optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. The optical sheet 10B is an optical sheet for a display device installed in front of a front passenger seat of a vehicle, and the extending direction of the light transmitting portion 3 has an angle of 1.5° or more and 20° or less, with respect to the second direction D2.

Since details of FIG. 1, FIG. 3, and FIG. 4 are described in the section "A-1. Optical sheet (first embodiment)" above, the description herein is omitted. Also, since FIG. 10 is described in the section "A-3. Optical sheet (fifth embodiment)" above, the description herein is omitted.

Since the optical sheet in the present embodiment includes an optical functional layer including a light transmitting portion having a predetermined cross-section and extending in a predetermined direction, and a light absorbing portion, the light transmittance, in the direction ±20° inclined toward the first direction with respect to the third direction, can be reduced. Specifically, when the light transmittance in the third direction is regarded as 100%, the relative transmittance, that is the ratio of the light transmittance in the direction ±20° inclined toward the first direction with respect to the third direction, can be made 10% or less.

Further, under a condition where the light-exit angle in the first direction D1 is controlled, when the extending direction of the light transmitting portion 3 has the angle $\theta$ of 1.5° or more and 20° or less, with respect to the second direction D2, the light-exit angle in the second direction D2 can be controlled.

Therefore, when the optical sheet in the present embodiment is used for a display device, the light-exit angle toward longitudinal direction and lateral direction of the display device can be controlled. More specifically, when used as an optical sheet for a display device installed in front of a front passenger seat of a vehicle, the emission of image light toward the driver's side can be controlled, and the reflection of image light on the windshield in front of the front passenger seat can be controlled.

The optical sheet in the present embodiment is an optical sheet for a display device installed in front of a front passenger seat of a vehicle.

Since other properties of the optical sheet in the present embodiment are similar to those described in the section "A-1. Optical sheet (first embodiment)" above, descriptions thereof is omitted herein.

B-4. Planar light source device (sixth embodiment)

As shown in FIG. 5 to FIG. 7 for example, the planar light source device 20 in the present embodiment includes the optical sheet 10F in the sixth embodiment described above, and a light source 25 that emits light incident on the optical sheet 10F. The planar light source device in the present embodiment is used for a front passenger seat display device.

Since details of FIG. 5 to FIG. 7 are described in the section "B-1. Planar light source device (first embodiment)" above, the description herein is omitted.

Since other members of the light source and planar light source device are described in the section "B-1. Planar light source device (first embodiment)" above, the description herein is omitted.

C-6. Display device (sixth embodiment)

The display device in the present embodiment includes the optical sheet in the sixth embodiment described above, and a display panel.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-6-1. Display device (first example of sixth embodiment)

The display device in the present embodiment includes a planar light source device including the optical sheet in the sixth embodiment described above, and a display panel stacked on the planar light source device.

FIG. 5 to FIG. 7 are a schematic plan view and cross-sectional views exemplifying the display device 50K in the present embodiment. Since FIG. 5 to FIG. 7 are described in the section "B-1. Planar light source device (first embodiment)" above, the description herein is omitted.

1. Planar light source device

Since the planar light source device is described in the section "B-4. Planar light source device (sixth embodiment)" above, the description herein is omitted.

2. Display panel and other members

Since the display panel and other members are described in the section "C-1-1. Display device (first example of first embodiment)" above, the description herein is omitted.

3. Use application

Since the use applications of the display device in the present embodiment are similar to the use applications described in the section "C-1-1. Display device (first example of first embodiment)" above, the description herein is omitted.

C-6-2. Display device (second example of sixth embodiment)

The display device in the present embodiment comprises a display panel, and the optical sheet in the sixth embodiment described above disposed on the observer side of the display panel.

FIG 9 is a schematic plan view and a cross-sectional view exemplifying the display device 50L in the present embodiment. Since FIG. 9 is described in the section "C-1-2. Display device (second example of first embodiment)" above, the description herein is omitted.

1. Optical sheet

Since the optical sheet is similar to the optical sheet described in the section "C-6-1. Display device (first example of sixth embodiment)" above, the description herein is omitted.

2. Display panel and other members

Since the display panel and other members are described in the section "C-1-2. Display device (second example of first embodiment)" above, the description herein is omitted.

3. Use application

Since the use applications of the display device in the present embodiment are similar to the use applications described in the section "C-1-1. Display device (first example of first embodiment)" above, the description herein is omitted.

C-7. Display device (seventh embodiment)

The display device in the present embodiment is a display device comprising an optical sheet and a display panel, wherein the optical sheet includes a substrate layer, and an optical functional layer stacked on one surface of the substrate layer; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; in the optical sheet, when the display device is installed, when a light transmittance in a normal line direction to a main surface of the optical sheet is regarded as 100%, a relative transmittance, that is a ratio of a light transmittance in a direction ±20° inclined laterally to the normal line direction, is 10% or less; and an extending direction of the light transmitting portion, viewed from the normal line direction, has an angle of 1.5° or more and 20° or less, with respect to a vertical direction.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-7-1. Display device (first example of seventh embodiment)

FIG. 5 to FIG. 7 are a schematic plan view and cross-sectional views exemplifying a display device in the present embodiment. Also, FIG. 1, FIG. 3, FIG. 4 and FIG. 10 are a schematic perspective view, cross-sectional views, and a plan view exemplifying an optical sheet in a display device in the present embodiment. As shown in FIG. 5 to FIG. 7, the display device 50M in the present embodiment includes a planar light source device 20 including the optical sheet 10G, and a liquid crystal panel 15 stacked on the planar light source device 20. As shown in FIG. 1, FIG. 3, FIG. 4 and FIG. 10, the optical sheet 10G in the present embodiment includes a substrate layer 1 and an optical functional layer 2 stacked on one surface of the substrate layer 1, and the optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. As shown in FIG. 10, in the optical sheet 10G, when the display device 50M is installed, and when the light transmittance in the normal line direction N (third direction D3 in FIG. 1, FIG. 3, FIG. 4 and FIG. 10) to a main surface S of the optical sheet is regarded as 100%, the relative transmittance, that is the ratio of the light transmittance in the direction ±20° inclined laterally to the normal line N, is 10% or less. Also, as shown in FIG. 3, in the optical sheet 10G, when the display device 50M is installed, an extending direction of the light transmitting portion 3, viewed from the normal line direction N, has an angle of 1.5° or more and 20° or less, with respect to the vertical direction.

Since details of FIG. 1, FIG. 3, and FIG. 4 are described in the section "A-1. Optical sheet (first embodiment)" above, the description herein is omitted. Since FIG. 10 are described in the section "A-3. Optical sheet (fifth embodiment)" above, the description herein is omitted. Also, since FIG. 5 to FIG. 7 are described in the section "B-1. Planar light source device (first embodiment)" above, the description herein is omitted.

The display device 50M in the present embodiment includes a predetermined optical sheet 10G. According to the optical sheet 10G in the present embodiment, when the display device is installed, since the relative transmittance, that is the ratio of the light transmittance in the direction ±20° inclined toward the lateral direction with respect to the normal line direction, is a predetermined value or less, the light-exit angle in the lateral direction of the display device can be controlled. Further, under a condition where the light-exit angle in the lateral direction is controlled, when the extending direction of the light transmitting portion, viewed from the normal line direction, has an angle θ of a predetermined range, with respect to the vertical direction, the light-exit angle in the longitudinal direction of the display device can be controlled.

Therefore, with the display device, the light-exit angle toward longitudinal direction and lateral direction can be controlled. More specifically, when installed in front of a front passenger seat of a vehicle, the emission of image light toward the driver's side can be controlled, and the reflection of image light on the windshield in front of the front passenger seat can be controlled.

1. Planar light source device

The planar light source device includes a predetermined optical sheet. As shown in FIG. 1, FIG. 3, FIG. 4 and FIG. 10, in the optical sheet 10G in the present embodiment, when the display device is installed, and when the light transmittance in the normal line direction N (third direction D3 in FIG. 1, FIG. 3, FIG. 4 and FIG. 10) to the main surface of the optical sheet is regarded as 100%, the relative transmittance, that is the ratio of the light transmittance in the direction ±20° inclined laterally to the normal line N, is 10% or less. The relative transmittance of light is preferably 5% or less.

Further, in the optical sheet in the present embodiment, when the display device is installed, the extending direction of the light transmitting portion, viewed from the normal line direction, has an angle of 1.5° or more and 20° or less, with respect to the vertical direction. The angle θ is 1.5° or more, may be 5° or more, and may be 10° or more. Meanwhile, angle θ is 20° or less, and may be 15° or less. That is, the angle θ is 1.5° or more and 20° or less, may be 5° or more and 20° or less, and may be 10° or more and 15° or less. When the angle θ is in the above range, the light-exit angle in the lateral direction can be controlled. Incidentally, in FIG. 1 and FIG. 3, the light transmitting portion 3 has the angle θ on the right side (+D1 side) with respect to the vertical direction. In this case, the left side (-D1 side) is preferably the driver's side. Meanwhile light transmitting portion 3 may have the angle θ on the left side (-D1 side) with respect to the second direction D2. In this case, the right side (+D1 side) is preferably the driver's side.

Since the properties of the optical sheet having the optical properties described above and other properties in the present embodiment are similar to those described in the section "A-1. Optical sheet (first embodiment)" above, descriptions thereof is omitted herein. Since other members of the planar light source device are described in the section "B-1. Planar light source device (first embodiment)" above, the description herein is omitted.

2. Display panel and other members

Since the display panel and other members are described in the section "C-1-1. Display device (first example of first embodiment)" above, the description herein is omitted.

3. Use application

Since the use applications of the display device in the present embodiment are similar to those described in the section "C-1-1. Display device (first example of first embodiment)" described above, the description herein is omitted.

C-7-2. Display device (second example of seventh embodiment)

FIG 9 is a schematic plan view and a cross-sectional view exemplifying a display device in the present embodiment. Also, FIG. 1, FIG. 3, FIG. 4 and FIG. 10 are a schematic perspective view, cross-sectional views, and a plan view exemplifying an optical sheet in a display device in the present embodiment. As shown in FIG. 9, the display device 50N in the present embodiment comprises a display panel 30, and an optical sheet 10G disposed on the observer side of the display panel 30. As shown in FIG. 1, FIG. 3, FIG. 4 and FIG. 10, the optical sheet 10G in the present embodiment includes a substrate layer 1 and an optical functional layer 2 stacked on one surface of the substrate layer 1, and the optical functional layer 2 includes a plurality of light transmitting portions 3 having a predetermined cross-section and extending in one direction, and a light absorbing portion 4 formed between the adjacent light transmitting portions 3, and the predetermined cross-section of the light transmitting portion 3 is a trapezoid, with a shorter upper base being a light-incident side. As shown in FIG. 10, in the optical sheet 10G, when the display device 50N is installed, and when the light transmittance in the normal line direction N (third direction D3 in FIG. 1 to FIG. 4) to the main surface S of the optical sheet is regarded as 100%, the relative transmittance, that is the ratio of the light transmittance in the direction ±20° inclined laterally to the normal line direction N, is 10% or less. Also, as shown in FIG. 3, in the optical sheet 10G, when the display device 50N is installed, the extending direction of the light transmitting portion 3, viewed from the normal line direction N, has an angle of 1.5° or more and 20° or less, with respect to the vertical direction.

Since details of FIG. 1, FIG. 3, and FIG. 4 are described in the section "A-1. Optical sheet (first embodiment)" above, the description herein is omitted. Since FIG. 10 is described in the section "A-3. Optical sheet (fifth embodiment)" above, the description herein is omitted. Also, since FIG. 9 is described in the section "C-1-2. Display device (second example of first embodiment)" above, the description herein is omitted.

1. Optical sheet

Since the optical sheet is similar to the optical sheet described in the section "C-7-1. Display device (first example of seventh embodiment)" above, the description herein is omitted.

2. Display panel and other members

Since the display panel and other members are described in the section "C-1-2. Display device (second example of first embodiment)" above, the description herein is omitted.

3. Use application

Since the use applications of the display device in the present embodiment are similar to those described in the section "C-1-1. Display device (first example of first embodiment)" described above, the description herein is omitted.

C-8. Display device (eighth embodiment)

The display device in the present embodiment is a display device comprising an optical sheet and a display panel, wherein the display device is installed in front of a front passenger seat of a vehicle; the optical sheet includes a substrate layer, and an optical functional layer stacked on one surface of the substrate layer; the substrate layer is a resin substrate; the optical functional layer includes a plurality of light transmitting portions having a predetermined cross-section and extending in one direction, and a light absorbing portion formed between the adjacent light transmitting portions; the predetermined cross-section of the light transmitting portion is a trapezoid, with a shorter upper base being a light-incident side; and in the optical sheet, when the display device is installed in front of a front passenger seat of a vehicle, an extending direction of the light transmitting portion, viewed from a normal line direction to a main surface of the optical sheet, has an angle of 1.5° or more and 20° or less, with respect to a vertical direction.

The display device in the present embodiment includes 2 further embodiments. The display device in the present embodiment may include a planar light source device, and the planar light source device may include the optical sheet described above. Also, in the display device in the present embodiment, the optical sheet described above may be disposed on the observer side of the display panel.

C-8-1. Display device (first example of eighth embodiment)

FIG. 5 to FIG. 7 are a schematic plan view and cross-sectional views exemplifying a display device in the present embodiment. Also, FIG. 1, FIG. 3, FIG. 4 and FIG. 10 are a schematic perspective view, cross-sectional views, and a plan view exemplifying an optical sheet in a display device in the present embodiment. As shown in FIG. 5 to FIG. 7, the display device 50O in the present embodiment includes a planar light source device 20 including the optical sheet 10H, and a liquid crystal panel 15 stacked on the planar light source device 20, and the display device is installed in front of a front passenger seat of a vehicle. As shown in FIG. 1, FIG. 3, FIG. 4 and FIG. 10, the optical sheet 10H in the present embodiment includes a substrate layer 1 and an optical functional layer 2 stacked on one surface of the substrate layer 1, the substrate layer 1 is a resin substrate; and the optical functional layer 2 includes a plurality of light transmitting portions 3 having a predetermined cross-section and extending in one direction and a light absorbing portion 4 formed between the adjacent light transmitting portions 3, and the predetermined cross-section of the light transmitting portion 3 is a trapezoid, with a shorter upper base being a light-incident side. In the optical sheet 10H, when the display device is installed in front of a front passenger seat of a vehicle, the extending direction of the light transmitting portion 3, viewed from the normal line direction N (third direction D3 in FIG. 1 to FIG. 4) to the main surface of the optical sheet 10H, has an angle of 1.5° or more and 20° or less, with respect to the vertical direction.

The display device 50O in the present embodiment includes a predetermined optical sheet 10H. Since the optical sheet 10H in the present embodiment includes an optical functional layer including a light transmitting portion having a predetermined cross-section and extending in a predetermined direction, and a light absorbing portion, when the display device is installed in front of a front passenger seat of a vehicle, the light transmittance, in the direction ±20° inclined laterally to the normal line direction, can be reduced. Specifically, when the light transmittance in the normal line direction is regarded as 100%, the relative transmittance, that is the ratio of the light transmittance in the direction ±20° inclined toward the lateral direction with respect to the normal line direction, can be made 10% or less. Therefore, the light-exit angle of the display device in lateral direction can be controlled.

Further, under a condition where the light-exit angle in the lateral direction is controlled, when the extending direction of the light transmitting portion, viewed from the normal line direction, has the angle $\theta$ of a predetermined range, with respect to the vertical direction, the light-exit angle in the longitudinal direction of the display device can be controlled. Therefore, in the display device in the present embodiment, the emission of image light toward the driver's side can be controlled, and the reflection of image light on the windshield in front of the front passenger seat can be controlled.

1. Planar light source device

The planar light source device includes a predetermined optical sheet. The optical sheet 10H in the present embodiment includes an optical functional layer including a light transmitting portion having a predetermined cross-section and extending in a predetermined direction, and a light absorbing portion. Thereby, when the display device 50O including the predetermined optical sheet 10H is installed in front of a front passenger seat of a vehicle, and when the light transmittance in the normal line direction N (third direction D3 in FIG. 1, FIG. 3, FIG. 4 and FIG. 10) to a main surface of the optical sheet 10H is regarded as 100%, the relative transmittance, that is the ratio of the light transmittance in the direction ±20° inclined laterally to the normal line direction N, can be made 10% or less. The relative transmittance of light is preferably 5% or less.

Further, in the optical sheet in the present embodiment, when the display device is installed in front of a front passenger seat of a vehicle, the extending direction of the light transmitting portion, viewed from the normal line direction, has the angle of 1.5° or more and 20° or less, with respect to the vertical direction. The angle $\theta$ is 1.5° or more, may be 5° or more, and may be 10° or more. Meanwhile, angle $\theta$ is 20° or less, and may be 15° or less. That is, the angle $\theta$ is 1.5° or more and 20° or less, may be 5° or more and 20° or less, and may be 10° or more and 15° or less. When the angle $\theta$ is in the above range, the light-exit angle in the lateral direction can be controlled. Incidentally, in FIG. 1 and FIG. 3, the light transmitting portion 3 has the angle θ on the right side (+D1 side) with respect to the vertical direction. In this case, the left side (-D1 side) is preferably the driver's side. Meanwhile light transmitting portion 3 may have the angle θ on the left side (-D1 side) with respect to the vertical direction. In this case, the right side (+D1 side) is preferably the driver's side.

Since other properties of the optical sheet in the present embodiment are similar to those described in the section "A-1. Optical sheet (first embodiment)" above, descriptions thereof is omitted herein. Since other members of the planar light source device are described in the section "B-1. Planar light source device (first embodiment)" above, the description herein is omitted.

2. Display panel and other members

Since the display panel and other members are described in the section "C-1-1. Display device (first example of first embodiment)" above, the description herein is omitted.

3. Use application

The display device in the present embodiment is installed in front of a front passenger seat of a vehicle. FIG. 8(a) is a schematic view of the front of inside a vehicle when a display device 50O in the present embodiment is installed in front of a front passenger seat of a vehicle. FIG. 8(b) is a plan view explaining the condition of the optical sheet of the display device in FIG. 8(a). In FIG. 8(a) and FIG. 8(b), the display device is disposed so that the lateral direction of the optical sheet is horizontal direction (the lateral direction of the vehicle), and the longitudinal direction is vertical direction, and the thickness direction is horizontal direction (the front and rear direction of the vehicle). Meanwhile, the installation attitude of the display device is not limited thereto.

C-8-2. Display device (second example of eighth embodiment)

FIG 9 is a schematic plan view and a cross-sectional view exemplifying a display device in the present embodiment. Also, FIG. 1, FIG. 3, FIG. 4 and FIG. 10 are a schematic perspective view, cross-sectional views, and a plan view exemplifying an optical sheet in a display device in the present embodiment. As shown in FIG. 9, the display device 50P in the present embodiment comprises a display panel 30, and an optical sheet 10H disposed on the observer side of the display panel 30. As shown in FIG. 1, FIG. 3, FIG. 4 and FIG. 10, the optical sheet 10H in the present embodiment includes a substrate layer 1 and an optical functional layer 2 stacked on one surface of the substrate layer 1; the optical functional layer 2 includes a plurality of light transmitting portions 3 having a predetermined cross-section and extending in one direction, and a light absorbing portion 4 formed between the adjacent light transmitting portions 3; and the predetermined cross-section of the light transmitting portion 3 is a trapezoid, with a shorter upper base being a light-incident side. As shown in FIG. 3, in the optical sheet 10H, when the display device 50P is installed, the extending direction of the light transmitting portion 3, viewed from the normal line direction N, has an angle of 1.5° or more and 20° or less, with respect to the vertical direction.

Since details of FIG. 1, FIG. 3, and FIG. 4 are described in the section "A-1. Optical sheet (first embodiment)" above, the description herein is omitted. Since FIG. 10 is described in the section "A-3. Optical sheet (fifth embodiment)" above, the description herein is omitted. Also, since FIG. 9 is described in the section "C-1-2. Display device (second example of first embodiment)" above, the description herein is omitted.

1. Optical sheet

Since the optical sheet is similar to the optical sheet described in the section "C-8-1. Display device (first example of eighth embodiment)" above, the description herein is omitted.

2. Display panel and other members

Since the display panel and other members are described in the section "C-1-2. Display device (second example of first embodiment)" above, the description herein is omitted.

3. Use application

Since the use applications of the display device in the present embodiment are similar to those described in the section "C-8-1. Display device (first example of eighth embodiment)" above, the description herein is omitted.

Incidentally, the present disclosure is not limited to the embodiments. The embodiments are exemplification, and any other variations are intended to be included in the technical scope of the present disclosure if they have substantially the same constitution as the technical idea described in the claim of the present disclosure and offer similar operation and effect thereto.

Examples

The present disclosure is hereinafter explained in further details with reference to Examples and Comparative Examples.

[Examples 1 to 18 and Comparative Examples 1 to 14]

An optical sheet including a substrate layer and an optical functional layer shown in FIG. 1 to FIG. 4 was produced. In this case, the angle of the light transmitting portion relative to the second direction (bias angle $\theta$), the leg inclination angles $\theta_{11}$ and $\theta_{12}$ in the trapezoidal cross-section, aperture ratio on the light-incident side, height Da of the light absorbing portion, OD value of the light absorbing portion, and refractive index difference Nt - Nr between the light transmitting portion and light absorbing portion were varied as shown in Table 1 and Table 2. Incidentally, the refractive index Nt of the light transmitting portion was 1.57 and the refractive index Nr of the light absorbing portion was 1.54 in the sample group 1 to sample group 3.

For the obtained optical sheet, the luminance of the light was measured, and the transmittance and relative transmittance were calculated as follows.

(Method for measuring)

Firstly, without disposing an optical sheet, the luminance of light, in the third direction D3, of the planar light source (an edge light type planar light source including an LED as a light source) alone was measured using a viewing angle property measuring device (EZ Contrast XL80 from ELDIM). Then, the planar light source (an edge light type planar light source including an LED as a light source) was disposed on the rear surface side (optical functional layer side) of the optical sheet, and the luminance of light transmitted through the optical sheet in the third direction D3, and the luminance of light transmitted in the direction ±30° inclined toward the first direction D1 with respect to the third direction D3, were measured with a viewing angle property measuring device (EZ Contrast XL80 from ELDIM) on the front surface side (substrate layer side). Then, the ratio of the luminance of light transmitted through the optical sheet in the third direction D3 with respect to the luminance of light of the planar light source alone in the third direction D3 was calculated as the transmittance of light transmitted through the optical sheet in the third direction D3. Similarly, the ratio of the luminance of light transmitted in the direction ±30° inclined toward the first direction D1 with respect to the third direction, with respect to the luminance of light of the planar light source alone in the third direction D3, was calculated as the transmittance of light transmitted in the direction ±30° inclined toward the first direction D1 with respect to the third direction D3. Finally, when the transmittance of the light transmitted through the optical sheet in the third direction D3 is regarded as 100%, the relative transmittance, that is the ratio of transmittance of the light transmitted in the direction ±30° inclined toward the first direction D1 with respect to the third direction D3, was calculated. The results are shown in Table 1 and Table 2.

Also, similar to those described above, the relative transmittance, that is the ratio of transmittance of the light transmitted in the direction ±20° inclined toward the first direction D1 with respect to the third direction D3, when the transmittance of the light transmitted through the optical sheet in the third direction D3 is regarded as 100%, was calculated.

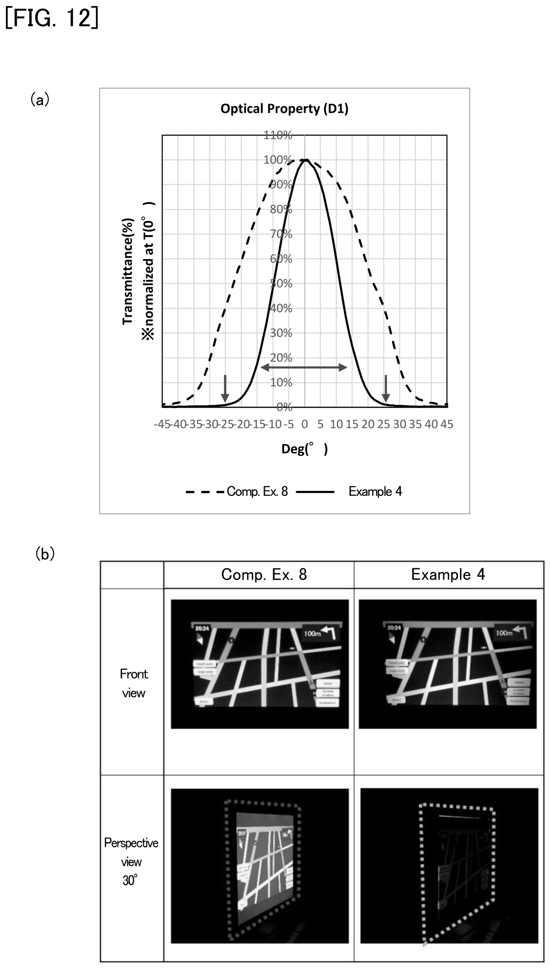

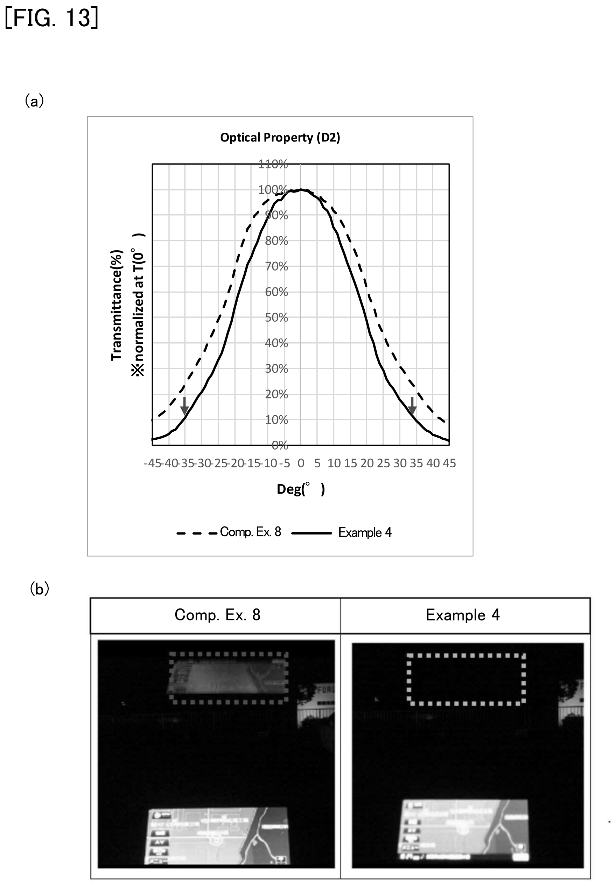

The results of measurement of the relative transmittance of the optical sheets in Example 4 and Comparative Example 8 are shown in FIG. 12(a) and FIG. 13(a). In FIG. 12(a), the viewing angle in lateral direction (first direction D1) is put on the horizontal axis, and the ratio (relative transmittance) of light transmittance at each viewing angle in lateral direction, when the light transmittance at a viewing angle of 0° is 100%, is put on the vertical axis. The optical sheet in Example 4 had a relative transmittance of 0.5% at a viewing angle of ±30° from the first direction D1, and a relative transmittance of 5.0% at a viewing angle of ±20° from the first direction D1. Meanwhile, the optical sheet in Comparative Example 8 had a relative transmittance of 17.8% at a viewing angle of ±30° from the first direction D1 and a relative transmittance of 57.8% at a viewing angle of ±20° from the first direction D1.

In FIG. 13(a), the viewing angle in longitudinal direction (second direction D2) is put on the horizontal axis, and the ratio (relative transmittance) of light transmittance at each viewing angle in longitudinal direction, when the light transmittance at a viewing angle of 0° is 100%, is put on the vertical axis. The optical sheet in Example 4 had a relative transmittance of 18% at a viewing angle of ±30° from the second direction D2. Meanwhile, the optical sheet in Comparative Example 8 had a relative transmittance of 31.1% at a viewing angle of ±30° from the second direction D2.

[Table 1]

| | | Sample group 1 | | | | | | | |
|---|---|---|---|---|---|---|---|---|---|
| | | Comp. Ex. 1 | Comp. Ex. 9 | Example 13 | Example 14 | Example 1 | Example 2 | Example 3 | Example 4 |
| Bias angle $\theta$ [° ] | | 0 | 1 | 1.5 | 2 | 5 | 10 | 15 | 20 |
| $\theta_{11}$ and $\theta_{12}$[° ] | | 4.50 | 4.50 | 4.50 | 4.50 | 4.50 | 4.50 | 4.50 | 4.50 |
| Light-incident side aperture ratio [%] | | 27.1 | 27.1 | 27.1 | 27.1 | 27.1 | 27.1 | 27.1 | 27.1 |
| Light absorbing portion height Da[$\mu$m] | | 120 | 120 | 120 | 120 | 120 | 120 | 120 | 120 |
| Light absorbing portion OD value | | 4.0 | 4.0 | 4.0 | 4.0 | 4.0 | 4.0 | 4.0 | 4.0 |
| Refractive index difference Nt-Nr | | 0.03 | 0.03 | 0.03 | 0.03 | 0.03 | 0.03 | 0.03 | 0.03 |
| Relative transmittance [%] | Lateral dir. ± 30° | 0.5% | 0.4% | 0.4% | 0.4% | 0.4% | 0.4% | 0.4% | 0.5% |
| | Lateral dir. ± 20° | 3.2% | 3.2% | 3.3% | 3.3% | 3.3% | 3.4% | 4.0% | 5.0% |
| | Longitudinal dir. ± 30° | 33.9% | 33.3% | 32.0% | 31.7% | 31.7% | 30.6% | 27.5% | 18.0% |
| Reflection on windshield | | Yes | Yes | No | No | No | No | No | No |

[Table 2]

| | | Sample group 2 | | | | | | | |
|---|---|---|---|---|---|---|---|---|---|
| | | Comp. Ex. 2 | Comp. Ex. 10 | Example 15 | Example 16 | Example 5 | Example 6 | Example 7 | Example 8 |
| Bias angle $\theta$ [° ] | | 0 | 1 | 1.5 | 2 | 5 | 10 | 15 | 20 |
| $\theta_{11}$ and $\theta_{12}$[° ] | | 4.75 | 4.75 | 4.75 | 4.75 | 4.75 | 4.75 | 4.75 | 4.75 |
| Light-incident side aperture ratio [%] | | 29.8 | 29.8 | 29.8 | 29.8 | 29.8 | 29.8 | 29.8 | 29.8 |
| Light absorbing portion height Da[$\mu$m] | | 120 | 120 | 120 | 120 | 120 | 120 | 120 | 120 |
| Light absorbing portion OD value | | 4.0 | 4.0 | 4.0 | 4.0 | 4.0 | 4.0 | 4.0 | 4.0 |
| Refractive index difference Nt-Nr | | 0.03 | 0.03 | 0.03 | 0.03 | 0.03 | 0.03 | 0.03 | 0.03 |
| Relative transmittance [%] | Lateral dir. ± 30° | 0.5% | 0.5% | 0.5% | 0.5% | 0.5% | 0.4% | 0.3% | 0.6% |
| | Lateral dir. ± 20° | 2.9% | 3.0% | 3.0% | 3.1% | 3.1% | 3.3% | 3.6% | 4.7% |
| | Longitudinal dir. ± 30° | 33.4% | 33.0% | 31.8% | 31.6% | 31.6% | 31.3% | 27.8% | 18.7% |
| Reflection on windshield | | Yes | Yes | No | No | No | No | No | No |

[Table 3]

| | | Sample group 3 | | | | | | | |
|---|---|---|---|---|---|---|---|---|---|
| | | Comp. Ex. 3 | Comp. Ex. 11 | Example 17 | Example 18 | Example 9 | Example 10 | Example 11 | Example 12 |
| Bias angle $\theta$ [° ] | | 0 | 1 | 1.5 | 2 | 5 | 10 | 15 | 20 |
| $\theta_{11}$ and $\theta_{12}$[° ] | | 5.00 | 5.00 | 5.00 | 5.00 | 5.00 | 5.00 | 5.00 | 5.00 |
| Light-incident side aperture ratio [%] | | 32.5 | 32.5 | 32.5 | 32.5 | 32.5 | 32.5 | 32.5 | 32.5 |
| Light absorbing portion height Da[$\mu$m] | | 120 | 120 | 120 | 120 | 120 | 120 | 120 | 120 |
| Light absorbing portion OD value | | 4.0 | 4.0 | 4.0 | 4.0 | 4.0 | 4.0 | 4.0 | 4.0 |
| Refractive index difference Nt-Nr | | 0.03 | 0.03 | 0.03 | 0.03 | 0.03 | 0.03 | 0.03 | 0.03 |
| Relative transmittance [%] | Lateral dir. ± 30° | 0.3% | 0.3% | 0.3% | 0.3% | 0.3% | 0.3% | 0.4% | 0.4% |
| | Lateral dir. ± 20° | 2.1% | 2.1% | 2.2% | 2.2% | 2.2% | 2.3% | 2.6% | 2.9% |
| | Longitudinal dir. ± 30° | 33.3% | 33.1% | 31.8% | 31.5% | 31.0% | 30.4% | 24.5% | 17.0% |
| Reflection on windshield | | Yes | Yes | No | No | No | No | No | No |

[Table 4]

| | | Sample group 4 | | | | | | | |
|---|---|---|---|---|---|---|---|---|---|
| | | Comp. Ex. 4 | Comp. Ex. 12 | Comp. Ex. 13 | Comp. Ex. 14 | Comp. Ex. 5 | Comp. Ex. 6 | Comp. Ex. 7 | Comp. Ex. 8 |
| Bias angle $\theta$ [° ] | | 0 | 1 | 1.5 | 2 | 5 | 10 | 15 | 20 |
| $\theta_{11}$ and $\theta_{12}$[° ] | | 3.40 | 3.40 | 3.40 | 3.40 | 3.40 | 3.40 | 3.40 | 3.40 |
| Light-incident side aperture ratio [%] | | 73.1 | 73.1 | 73.1 | 73.1 | 73.1 | 73.1 | 73.1 | 73.1 |
| Light absorbing portion height Da[$\mu$m] | | 102 | 102 | 102 | 102 | 102 | 102 | 102 | 102 |
| Light absorbing portion OD value | | 2.87 | 2.87 | 2.87 | 2.87 | 2.87 | 2.87 | 2.87 | 2.87 |
| Refractive index difference Nt-Nr | | 0.08 | 0.08 | 0.08 | 0.08 | 0.08 | 0.08 | 0.08 | 0.08 |
| Relative transmittance [%] | Lateral dir. ± 30° | 9.9% | 10.0% | 10.0% | 10.0% | 10.0% | 11.3% | 16.0% | 17.8% |
| | Lateral dir. ± 20° | 53.8% | 54.0% | 54.1% | 54.2% | 55.1% | 55.9% | 57.6% | 57.8% |
| | Longitudinal dir. ± 30° | 35.4% | 35.6% | 35.8% | 35.7% | 35.5% | 34.3% | 32.2% | 31.1% |
| Reflection on windshield | | Yes | Yes | Yes | Yes | Yes | Yes | Yes | Yes |

The optical sheets of Example 4 and Comparative Example 8 were used for a display device, and the display device was observed from the front, and the display device was observed obliquely from a position where the lateral viewing angle was approximately 30°. FIG. 12(b) shows the state of the display device as observed. In Comparative Example 8, the image light was visible from a position where the lateral viewing angle was approximately 30°, whereas in Example 4, it was confirmed that the image light was not visible from a position where the lateral viewing angle was approximately 30°.

Assuming a case where the optical sheets in Examples 1 to 18 and Comparative Examples 1 to 14 were used for a front passenger seat display device, the presence or absence of reflection of image light on the windshield in front of the front passenger seat was observed. In Comparative Example 8, reflection of the image light on the windshield was observed, and it was confirmed that reflection was suppressed in Example 4 (FIG. 13(b)). Also, the presence or absence of reflection on the windshield, when the optical sheets in other Examples and Comparative Examples were used, are shown in Table 1 and Table 2. From Table 1 and Table 2, it was confirmed that reflections on the windshield were suppressed when the relative transmittance that is the ratio of the light transmittance in the direction ±30° inclined toward the second direction with respect to the third direction, when the light transmittance in the third direction is regarded as 100%, was 32% or less.

In other words, the present disclosure can provide the following inventions.

[1] An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and
an extending direction of the light transmitting portion has an angle of 5° or more and 20° or less, with respect to the second direction.

[2] An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
the optical sheet is an optical sheet for a display device installed in front of a front passenger seat of a vehicle; and
an extending direction of the light transmitting portion has an angle of 5° or more and 20° or less, with respect to the second direction.

[3] The optical sheet according to [2], wherein, when a light transmittance in a third direction perpendicular to the first direction and the second direction is regarded as 100%, a relative transmittance, that is a ratio of a light transmittance in a direction ±30° inclined toward the first direction with respect to the third direction, is 1% or less.
[4] An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and
an extending direction of the light transmitting portion has an angle of 1.5° or more and 20° or less, with respect to the second direction.

[5] An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
the optical sheet is an optical sheet for a display device installed in front of a front passenger seat of a vehicle; and
an extending direction of the light transmitting portion has an angle of 1.5° or more and 20° or less, with respect to the second direction.

[6] The optical sheet according to [5], wherein, when a light transmittance in a third direction perpendicular to the first direction and the second direction is regarded as 100%, a relative transmittance, that is a ratio of a light transmittance in a direction ±30° inclined toward the first direction with respect to the third direction, is 1% or less.
[7] An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
when a light transmittance in a third direction perpendicular to the first direction and the second direction is regarded as 100%, a relative transmittance, that is a ratio of a light transmittance in a direction ±20° inclined toward the first direction with respect to the third direction, is 10% or less; and
an extending direction of the light transmitting portion has an angle of 1.5° or more and 20° or less, with respect to the second direction.

[8] An optical sheet comprising a substrate layer, and an optical functional layer stacked on one surface of the substrate layer, wherein

the substrate layer is a resin substrate;
in a plan view, the optical sheet has a rectangular shape including a pair of first sides extending in a first direction and a pair of second sides extending in a second direction;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
the optical sheet is an optical sheet for a display device installed in front of a front passenger seat of a vehicle; and
an extending direction of the light transmitting portion has an angle of 1.5° or more and 20° or less, with respect to the second direction.

[9] The optical sheet according to [8], wherein, when a light transmittance in a third direction perpendicular to the first direction and the second direction is regarded as 100%, a relative transmittance, that is a ratio of a light transmittance in a direction ±20° inclined toward the first direction with respect to the third direction, is 10% or less.
[10] The optical sheet according to any one of [1] to [9], wherein an angle formed by an interface between the light transmitting portion and the light absorbing portion, with respect to a normal line to a layer surface of the optical functional layer, is 4.5° or more.
[11] The optical sheet according to any one of [1] to [10], wherein an aperture ratio of the optical functional layer on a light-incident side is 35% or less.
[12] The optical sheet according to any one of [1] to [11], wherein a height of the light absorbing portion is 120 μm or more.
[13] The optical sheet according to any one of [1] to [12], wherein an OD value of the light absorbing portion is 3.5 or more.
[14] The optical sheet according to any one of [1] to [13], wherein a difference Nt - Nr between a refractive index Nt of the light transmitting portion and a refractive index Nr of the light absorbing portion is 0.05 or less.
[15] The optical sheet according to [1], wherein the optical sheet is an optical sheet for a display device installed in front of a front passenger seat of a vehicle.
[16] The optical sheet according to any one of [1] to [15], wherein a retardation of the substrate layer is 3000 nm or more.
[17] A planar light source device comprising the optical sheet according to any one of [1] to [16]; and
a light source that emits light incident on the optical sheet.
[18] A display device comprising the planar light source device according to [17]; and
a display panel stacked on the planar light source device.
[19] A display device comprising a planar light source device including an optical sheet; and a display panel stacked on the planar light source device, wherein

the optical sheet includes a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed,
when a light transmittance in a normal line direction to a main surface of the optical sheet is regarded as 100%, a relative transmittance, that is a ratio of a light transmittance in a direction ±30° inclined laterally to the normal line direction, is 1% or less; and
an extending direction of the light transmitting portion, viewed from the normal line direction, has an angle of 5° or more and 20° or less, with respect to a vertical direction.

[20] A display device comprising a planar light source device including an optical sheet; and a display panel stacked on the planar light source device, wherein

the display device is installed in front of a front passenger seat of a vehicle;
the optical sheet is an optical sheet including a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed in front of a front passenger seat of a vehicle,
an extending direction of the light transmitting portion, viewed from a normal line direction to a main surface of the optical sheet, has an angle of 5° or more and 20° or less, with respect to a vertical direction.

[21] The display device according to [20], wherein, in the optical sheet, when the display device is installed in front of a front passenger seat of a vehicle,
when a light transmittance in the normal line direction to a main surface of the optical sheet is regarded as 100%, a relative transmittance, that is a ratio of a light transmittance in a direction ±30° inclined laterally to the normal line direction, is 1% or less.
[22] A display device comprising an optical sheet and a display panel, wherein

the optical sheet includes a substrate layer, and an optical functional layer stacked on one surface of the substrate layer;

the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed,
when a light transmittance in a normal line direction to a main surface of the optical sheet is regarded as 100%, a relative transmittance, that is a ratio of a light transmittance in a direction ±30° inclined laterally to the normal line direction, is 1% or less; and
an extending direction of the light transmitting portion, viewed from the normal line direction, has an angle of 1.5° or more and 20° or less, with respect to a vertical direction.

[23] A display device comprising an optical sheet and a display panel, wherein

the display device is installed in front of a front passenger seat of a vehicle;
the optical sheet is an optical sheet including a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed in front of a front passenger seat of a vehicle,
an extending direction of the light transmitting portion, viewed from a normal line direction to a main surface of the optical sheet, has an angle of 1.5° or more and 20° or less, with respect to a vertical direction.

[24] The display device according to [23], wherein, in the optical sheet, when the display device is installed in front of a front passenger seat of a vehicle,
when a light transmittance in the normal line direction to a main surface of the optical sheet is regarded as 100%, a relative transmittance, that is a ratio of a light transmittance in a direction ±30° inclined laterally to the normal line direction, is 1% or less.
[25] A display device comprising an optical sheet and a display panel, wherein

the optical sheet includes a substrate layer, and an optical functional layer stacked on one surface of the substrate layer;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed,
when a light transmittance in a normal line direction to a main surface of the optical sheet is regarded as 100%, a relative transmittance, that is a ratio of a light transmittance in a direction ±20° inclined laterally to the normal line direction, is 10% or less; and
an extending direction of the light transmitting portion, viewed from the normal line direction, has an angle of 1.5° or more and 20° or less, with respect to a vertical direction.

[26] A display device comprising an optical sheet and a display panel, wherein

the display device is installed in front of a front passenger seat of a vehicle;
the optical sheet includes a substrate layer, and an optical functional layer stacked on one surface of the substrate layer;
the substrate layer is a resin substrate;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side; and

in the optical sheet, when the display device is installed in front of a front passenger seat of a vehicle, an extending direction of the light transmitting portion, viewed from a normal line direction to a main surface of the optical sheet, has an angle of 1.5° or more and 20° or less, with respect to a vertical direction.

[27] The display device according to [26], wherein, in the optical sheet, when the display device is installed in front of a front passenger seat of a vehicle,
when a light transmittance in the normal line direction to a main surface of the optical sheet is regarded as 100%, a relative transmittance, that is a ratio of a light transmittance in a direction ±20° inclined laterally to the normal line direction, is 10% or less.
[28] The display device according to any one of [22] to [27], wherein the display device includes a planar light source device, and the planar light source device includes the optical sheet.
[29] The display device according to any one of [22] to [27], wherein the optical sheet is disposed on an observer side of the display panel.
[30] The display device according to [29], wherein the display device is an organic electroluminescence display device.
[31] The display device according to any one of [19] to [29], wherein the display device is a liquid crystal display device.

Reference Signs List

1 substrate layer
2 optical functional layer
3 light transmitting portion
4 light absorbing portion
10 optical sheet
15 liquid crystal panel
20 planar light source device
21 light guide plate
25 light source
26 light diffuser plate
27 prism layer
28 reflective type polarizing plate
50 display device

**Claims**

**1.** An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and
an extending direction of the light transmitting portion has an angle of 5° or more and 20° or less, with respect to the second direction.

**2.** An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;

the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
the optical sheet is an optical sheet for a display device installed in front of a front passenger seat of a vehicle; and
an extending direction of the light transmitting portion has an angle of 5° or more and 20° or less, with respect to the second direction.

**3.** The optical sheet according to claim 2, wherein, when a light transmittance in a third direction perpendicular to the first direction and the second direction is regarded as 100%, a relative transmittance, that is a ratio of a light transmittance in a direction ±30° inclined toward the first direction with respect to the third direction, is 1% or less.

**4.** An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
when a light transmittance in a third direction perpendicular to the first direction and the second direction is regarded as 100%, a relative transmittance, that is a ratio of a light transmittance in a direction ±30° inclined toward the first direction with respect to the third direction, is 1% or less; and
an extending direction of the light transmitting portion has an angle of 1.5° or more and 20° or less, with respect to the second direction.

**5.** An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
the optical sheet is an optical sheet for a display device installed in front of a front passenger seat of a vehicle; and
an extending direction of the light transmitting portion has an angle of 1.5° or more and 20° or less, with respect to the second direction.

**6.** The optical sheet according to claim 5, wherein, when a light transmittance in a third direction perpendicular to the first direction and the second direction is regarded as 100%, a relative transmittance, that is a ratio of a light transmittance in a direction ±30° inclined toward the first direction with respect to the third direction, is 1% or less.

**7.** An optical sheet comprising a substrate layer, and an optical functional layer stacked on one surface of the substrate layer, wherein

the optical sheet has a rectangular shape including a pair of first sides extending in a first direction and a pair of second sides extending in a second direction in a plan view;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
when a light transmittance in a third direction perpendicular to the first direction and the second direction is regarded as 100%, a relative transmittance, that is a ratio of a light transmittance in a direction ±20° inclined toward the first direction with respect to the third direction, is 10% or less; and
an extending direction of the light transmitting portion has an angle of 1.5° or more and 20° or less, with respect to the second direction.

**8.** An optical sheet comprising a substrate layer, and an optical functional layer stacked on one surface of the substrate layer, wherein

the substrate layer is a resin substrate;
in a plan view, the optical sheet has a rectangular shape including a pair of first sides extending in a first direction and a pair of second sides extending in a second direction;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
the optical sheet is an optical sheet for a display device installed in front of a front passenger seat of a vehicle; and
an extending direction of the light transmitting portion has an angle of 1.5° or more and 20° or less, with respect to the second direction.

**9.** The optical sheet according to claim 8, wherein, when a light transmittance in a third direction perpendicular to the first direction and the second direction is regarded as 100%, a relative transmittance, that is a ratio of a light transmittance in a direction ±20° inclined toward the first direction with respect to the third direction, is 10% or less.

**10.** The optical sheet according to any one of claims 1 to 9, wherein an angle formed by an interface between the light transmitting portion and the light absorbing portion, with respect to a normal line to a layer surface of the optical functional layer, is 4.5° or more.

**11.** The optical sheet according to any one of claims 1 to 9, wherein an aperture ratio of the optical functional layer on a light-incident side is 35% or less.

**12.** The optical sheet according to any one of claims 1 to 9, wherein a height of the light absorbing portion is 120 μm or more.

**13.** The optical sheet according to any one of claims 1 to 9, wherein an OD value of the light absorbing portion is 3.5 or more.

**14.** The optical sheet according to any one of claims 1 to 9, wherein a difference Nt - Nr between a refractive index Nt of the light transmitting portion and a refractive index Nr of the light absorbing portion is 0.05 or less.

**15.** The optical sheet according to claim 1, wherein the optical sheet is an optical sheet for a display device installed in front of a front passenger seat of a vehicle.

**16.** The optical sheet according to any one of claims 4 to 9, wherein a retardation of the substrate layer is 3000 nm or more.

**17.** A planar light source device comprising the optical sheet according to any one of claims 1 to 9; and
a light source that emits light incident on the optical sheet.

**18.** A display device comprising the planar light source device according to claim 17; and
a display panel stacked on the planar light source device.

**19.** A display device comprising a planar light source device including an optical sheet; and a display panel stacked on the planar light source device, wherein

the optical sheet includes a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed,
when a light transmittance in a normal line direction to a main surface of the optical sheet is regarded as 100%, a relative transmittance, that is a ratio of a light transmittance in a direction ±30° inclined laterally to the normal line direction, is 1% or less; and
an extending direction of the light transmitting portion, viewed from the normal line direction, has an angle of 5° or more and 20° or less, with respect to a vertical direction.

**20.** A display device comprising a planar light source device including an optical sheet; and a display panel stacked on the planar light source device, wherein

the display device is installed in front of a front passenger seat of a vehicle;
the optical sheet is an optical sheet including a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed in front of a front passenger seat of a vehicle,
an extending direction of the light transmitting portion, viewed from a normal line direction to a main surface of the optical sheet, has an angle of 5° or more and 20° or less, with respect to a vertical direction.

**21.** The display device according to claim 20, wherein, in the optical sheet, when the display device is installed in front of a front passenger seat of a vehicle,
when a light transmittance in the normal line direction to a main surface of the optical sheet is regarded as 100%, a relative transmittance, that is a ratio of a light transmittance in a direction ±30° inclined laterally to the normal line direction, is 1% or less.

**22.** A display device comprising an optical sheet and a display panel, wherein

the optical sheet includes a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed,
when a light transmittance in a normal line direction to a main surface of the optical sheet is regarded as 100%, a relative transmittance, that is a ratio of a light transmittance in a direction ±30° inclined laterally to the normal line direction, is 1% or less; and
an extending direction of the light transmitting portion, viewed from the normal line direction, has an angle of 1.5° or more and 20° or less, with respect to a vertical direction.

**23.** A display device comprising an optical sheet and a display panel, wherein

the display device is installed in front of a front passenger seat of a vehicle;
the optical sheet is an optical sheet including a substrate layer, and an optical functional layer stacked on one surface of the substrate layer;
the optical functional layer
includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed in front of a front passenger seat of a vehicle,

an extending direction of the light transmitting portion, viewed from a normal line direction to a main surface of the optical sheet, has an angle of 1.5° or more and 20° or less, with respect to a vertical direction.

**24.** The display device according to claim 23, wherein, in the optical sheet, when the display device is installed in front of a front passenger seat of a vehicle,
when a light transmittance in the normal line direction to a main surface of the optical sheet is regarded as 100%, a relative transmittance, that is a ratio of a light transmittance in a direction ±30° inclined laterally to the normal line direction, is 1% or less.

**25.** A display device comprising an optical sheet and a display panel, wherein

the optical sheet includes a substrate layer, and an optical functional layer stacked on one surface of the substrate layer;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side;
in the optical sheet, when the display device is installed,
when a light transmittance in a normal line direction to a main surface of the optical sheet is regarded as 100%, a relative transmittance, that is a ratio of a light transmittance in a direction ±20° inclined laterally to the normal line direction, is 10% or less; and
an extending direction of the light transmitting portion, viewed from the normal line direction, has an angle of 1.5° or more and 20° or less, with respect to a vertical direction.

**26.** A display device comprising an optical sheet and a display panel, wherein

the display device is installed in front of a front passenger seat of a vehicle;
the optical sheet includes a substrate layer, and an optical functional layer stacked on one surface of the substrate layer;
the substrate layer is a resin substrate;
the optical functional layer includes a plurality of light transmitting portions having a predetermined cross-section and extending in one direction, and a light absorbing portion formed between the adjacent light transmitting portions;
the predetermined cross-section of the light transmitting portion is a trapezoid, with a shorter upper base being a light-incident side; and
in the optical sheet, when the display device is installed in front of a front passenger seat of a vehicle,
an extending direction of the light transmitting portion, viewed from a normal line direction to a main surface of the optical sheet, has an angle of 1.5° or more and 20° or less, with respect to a vertical direction.

**27.** The display device according to claim 26, wherein, in the optical sheet, when the display device is installed in front of a front passenger seat of a vehicle,
when a light transmittance in the normal line direction to a main surface of the optical sheet is regarded as 100%, a relative transmittance, that is a ratio of a light transmittance in a direction ±20° inclined laterally to the normal line direction, is 100 or less.

**28.** The display device according to any one of claims 22 to 27, wherein the display device includes a planar light source device, and the planar light source device includes the optical sheet.

**29.** The display device according to any one of claims 22 to 27, wherein the optical sheet is disposed on an observer side of the display panel.

**30.** The display device according to claim 29, wherein the display device is an organic electroluminescence display device.

**31.** The display device according to any one of claims 19 to 27, wherein the display device is a liquid crystal display device.

[FIG. 1]

L1
10
(10A～10H)
L2
L2
L1
I
I
Observer
Up
Light source
1
(Vertical direction)
Down
D3
D2
D1
4
3
2
Left
Right
(Horizontal direction)

[FIG. 2]

Relative
transmittance
100%
Relative
transmittance
≦1%
N
Relative
transmittance
≦1%
10
(10A,10B,
10C,10D)
D3
D1
Pout
−30°
+30°
S
Observer
1
2
Light source
Pin
2a
3
4
Left
Right
(Horizontal direction)

[FIG. 3]

10
(10A～10H)
BL
L1
θ
L2
(L2b)
Up
(Vertical
direction)
Down
L2
(L2a)
θ
θ
θ
D2
D1
D3
L1
3
4
Left
Right
(Horizontal direction)

[FIG. 4]

10
(10A～10H)
2
2a
1
Pin
4a
Pout
4b
3
4
Right
Pa
Wa
(Horizontal direction)
θ 11
Lc
θ 12
La
Left
Lb
D1
Ld
D3
Da
Light source
Observer

[FIG. 5]

50
(50A,50B,50C,50D,
50I,50K,50M,50O)
10
(10A～10H)
III
25
25
28
3
4
2
1
40
II
29
Up
Vertical
direction
Down
III
II
Horizontal
direction
23
22
27a
23
21
26
27
14
13
12
20
15
Thickness direction
Light source
Observer

[FIG. 6]

10
(10A,10B,10C,10D,10E,10F)
15
50
(50A,50B,50C,50D,
50I,50K,50M,50O)
21
29
23
22
26
27
27a
27a
28
2
1
14
12
13
40
Right
Horizontal direction
Left
Light source
Observer
Thickness direction

[FIG. 7]

50
(50A,50B,50C,50D,
50I,50K,50M,50O)
10
(10A,10B,10C,10D,10E,10F)
15
25
21
27
29
26
28
2
1
14
12
13
27a
40
L21
L22
Up
Vertical
direction
Down
23
23
23
22
Light source
Observer
Thickness direction

[FIG. 8]

(a)

50
(50A～50P)

(b)

3
4
50
(50A～50P)
Up
θ
K/3
θ
K
Vertical
direction
θ
K/3
θ
D2
Down
D1
D3
BL
Left
Right
Horizontal direction

[FIG. 9]

10
(10A～10H)
50
(50E,50F, 50G,50H,
50J,50L,50N,50P)
30
2
1
40
Right
Horizontal
direction
Left
Light source
Observer
Thickness direction

[FIG. 10]

Relative
transmittance
100%
Relative
transmittance
≦10%
Relative
transmittance
≦10%
N
10
(10E,10F,
10G,10H)
D3
D1
Pout
−20°
+20°
S
Observer
1
2
Light source
Pin
2a
3
4
Left
Right
(Horizontal direction)

[FIG. 11]

(a)
D3
D2
D1
90
Observer
Light source
31
34
33
32
(b)
100

[FIG. 12]

Optical Property (D1)
Transmittance(%)
※normalized at T(0° )
110%
100%
90%
80%
70%
60%
50%
40%
30%
20%
10%
0%
-45-40-35-30-25-20-15-10 -5 0 5 10 15 20 25 30 35 40 45
Deg(° )
Comp. Ex. 8
Example 4

(b)

| | Comp. Ex. 8 | Example 4 |
|---|---|---|
| Front view | | |
| Perspective view 30° | | |

[FIG. 13]

(a)

Optical Property (D2)
Transmittance(%)
※normalized at T(0° )
110%
100%
90%
80%
70%
60%
50%
40%
30%
20%
10%
0%
-45-40-35-30-25-20-15-10-5 0 5 10 15 20 25 30 35 40 45
Deg(° )
Comp. Ex. 8
Example 4

(b)

Comp. Ex. 8
Example 4

# INTERNATIONAL SEARCH REPORT

International application No. **PCT/JP2024/017814**

**A. CLASSIFICATION OF SUBJECT MATTER**

***G02B 5/00***(2006.01)i; ***F21S 2/00***(2016.01)i; ***F21V 5/00***(2018.01)i; ***F21V 9/08***(2018.01)i; ***F21V 9/40***(2018.01)i; ***G02F 1/1335***(2006.01)i; ***G02F 1/13357***(2006.01)i; ***H10K 59/10***(2023.01)i; *F21Y 101/00*(2016.01)n; *F21Y 115/10*(2016.01)n

FI: G02B5/00 Z; F21S2/00 431; F21V5/00 530; F21V9/08 400; F21V9/40 400; G02F1/1335 500; G02F1/13357; H10K59/10; F21Y101:00 100; F21Y115:10

According to International Patent Classification (IPC) or to both national classification and IPC

**B. FIELDS SEARCHED**

Minimum documentation searched (classification system followed by classification symbols)

G02B5/00; F21S2/00; F21V5/00; F21V9/08; F21V9/40; G02F1/1335; G02F1/13357; H10K59/10; F21Y101/00; F21Y115/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US 2020/0119313 A1 (CHENGDU BOE OPTOELECTRONICS TECHNOLOGY CO., LTD.) 16 April 2020 (2020-04-16) paragraphs [0050]-[0060], [0064], [0069]-[0074], fig. 1, 4-6 | 2, 5, 8, 10-14, 16, 23, 26, 29-31 |
| Y | | 1-31 |
| Y | US 2022/0244585 A1 (INNOLUX CORPORATION) 04 August 2022 (2022-08-04) claims 1-2, 4, 11, paragraphs [0003], [0024], [0027], fig. 1-4 | 1-31 |
| Y | US 2021/0341769 A1 (REALD SPARK, LLC.) 04 November 2021 (2021-11-04) paragraph [0230], fig. 6A | 1, 3-4, 6-7, 9-16, 19, 21-22, 24-25, 27 |
| A | WO 2018/181966 A1 (DAI NIPPON PRINTING CO., LTD.) 04 October 2018 (2018-10-04) entire text, all drawings | 1-31 |
| A | JP 2019-066549 A (OKI ELECTRIC IND CO., LTD.) 25 April 2019 (2019-04-25) entire text, all drawings | 1-31 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 June 2024** | **25 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/017814**

| Patent document cited in search report | Publication date (day/month/year) | Patent family member(s) | Publication date (day/month/year) |
|---|---|---|---|
| US 2020/0119313 A1 | 16 April 2020 | CN 109273508 A | |
| US 2022/0244585 A1 | 04 August 2022 | CN 114859596 A | |
| US 2021/0341769 A1 | 04 November 2021 | US 2021/0341768 A1 | |
| | | WO 2021/222606 A1 | |
| | | WO 2021/222615 A1 | |
| | | EP 4143042 A1 | |
| | | EP 4143041 A1 | |
| | | CN 115768642 A | |
| | | CN 115768643 A | |
| WO 2018/181966 A1 | 04 October 2018 | US 2021/0397041 A1 entire text, all drawings | |
| | | US 2022/0299820 A1 | |
| | | US 2023/0324735 A1 | |
| | | EP 3605157 A1 | |
| | | JP 2023-40121 A | |
| JP 2019-066549 A | 25 April 2019 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009080198 A
- JP 2015014681 A
- JP 2017215440 A
- JP 2006171701 A